(19) Europäisches Patentamt
European Patent Office
Office européen des brevets

(11) EP 4 503 130 A1

(12) EUROPEAN PATENT APPLICATION
published in accordance with Art. 153(4) EPC

(43) Date of publication:
**05.02.2025 Bulletin 2025/06**

(21) Application number: **23779481.3**

(22) Date of filing: **13.03.2023**

(51) International Patent Classification (IPC):
***H01L 27/146** (2006.01)* ***G02B 3/00** (2006.01)*
***G02B 3/08** (2006.01)* ***H04N 25/70** (2023.01)*

(52) Cooperative Patent Classification (CPC):
**G02B 3/00; G02B 3/08; H01L 27/146; H04N 25/70**

(86) International application number:
**PCT/JP2023/009513**

(87) International publication number:
**WO 2023/189459 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.03.2022 JP 2022051131**

(71) Applicant: **Sony Semiconductor Solutions Corporation**
**Atsugi-shi, Kanagawa 243-0014 (JP)**

(72) Inventors:
- **SHIGETOSHI, Takushi**
  **Atsugi-shi, Kanagawa 243-0014 (JP)**
- **SAKAMOTO, Toshiki**
  **Kikuchi-gun, Kumamoto 869-1102 (JP)**
- **NOUDO, Shinichiro**
  **Atsugi-shi, Kanagawa 243-0014 (JP)**
- **MASUDA, Yoshiaki**
  **Atsugi-shi, Kanagawa 243-0014 (JP)**
- **TAGUCHI, Yukari**
  **Kikuchi-gun, Kumamoto 869-1102 (JP)**
- **KAWANO, Hiroyuki**
  **Kikuchi-gun, Kumamoto 869-1102 (JP)**

(74) Representative: **MFG Patentanwälte**
**Meyer-Wildhagen Meggle-Freund**
**Gerhard PartG mbB**
**Amalienstraße 62**
**80799 München (DE)**

# (54) PHOTODETECTION DEVICE, METHOD FOR MANUFACTURING PHOTODETECTION DEVICE, AND ELECTRONIC APPARATUS

(57) The present disclosure relates to a photodetection device, a method of manufacturing the photodetection device, and an electronic device, which are capable of improving a light condensing effect of a microlens in units of pixels and improving optical characteristics. The photodetection device includes pixels each including a photoelectric conversion section that photoelectrically converts incident light, a microlens that condenses the incident light on the photoelectric conversion section, and a plurality of protrusions formed on the microlens. The pixels each include two or more of the protrusions in which at least one of a width, a height, or a density is different. The present disclosure can be applied to, for example, a solid-state imaging device or the like.

FIG. 4

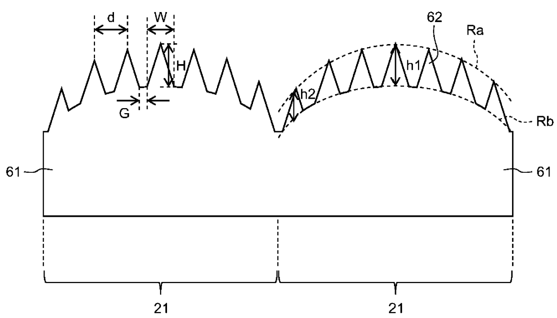


EP 4 503 130 A1

## Description

TECHNICAL FIELD

The present disclosure relates to a photodetection device, a method of manufacturing the photodetection device, and an electronic device, and more particularly relates to a photodetection device, a method of manufacturing the photodetection device, and an electronic device that are capable of improving a light condensing effect of a microlens in units of pixels and improving optical characteristics.

BACKGROUND ART

In the solid-state imaging element, a photoelectric conversion section is formed for each of a plurality of pixels arranged in a two-dimensional matrix, and a signal charge is generated in the photoelectric conversion section according to the amount of received light. Then, the signal charge generated by the photoelectric conversion section is transferred and amplified to obtain an image signal.

In the solid-state imaging element, a microlens is provided for each pixel in order to efficiently cause incident light to be incident on the photoelectric conversion section. For example, Patent Document 1 proposes a method of suppressing reflection on a surface of a microlens by forming irregularities having a wavelength equal to or less than a wavelength of light on the surface of the microlens. Furthermore, Patent Document 1 proposes a structure that improves light condensing performance by changing the size of the unevenness according to the pixel position.

CITATION LIST

PATENT DOCUMENT

Patent Document 1: Japanese Patent Application Laid-Open No. 2012-174885

SUMMARY OF THE INVENTION

PROBLEMS TO BE SOLVED BY THE INVENTION

However, in the manufacturing method disclosed in Patent Document 1, high processing accuracy and reproducibility cannot be obtained, and thus the fine uneven structure disclosed in Patent Document 1 cannot be created at a mass production level. Furthermore, the effect of improving the optical characteristics of the solid-state imaging element is limited only by changing the size of the unevenness on the microlens according to the pixel position.

The present disclosure has been made in view of such a situation, and an object thereof is to improve a light condensing effect of a microlens in units of pixels and to improve optical characteristics.

SOLUTIONS TO PROBLEMS

A photodetection device according to a first aspect of the present disclosure includes pixels each including a photoelectric conversion section that photoelectrically converts incident light, a microlens that condenses the incident light on the photoelectric conversion section, and a plurality of protrusions formed on the microlens, in which the pixels each include two or more of the protrusions in which at least one of a width, a height, or a density is different.

An electronic device according to a second aspect of the present disclosure includes a photodetection device including pixels each including a photoelectric conversion section that photoelectrically converts incident light, a microlens that condenses the incident light on the photoelectric conversion section, and a plurality of protrusions formed on the microlens, in which the pixels each include two or more of the protrusions in which at least one of a width, a height, or a density is different.

In the first and second aspects of the present disclosure, there are provided pixels each including a photoelectric conversion section that photoelectrically converts incident light, a microlens that condenses the incident light on the photoelectric conversion section, and a plurality of protrusions formed on the microlens, in which the pixels each include two or more of the protrusions in which at least one of a width, a height, or a density is different.

In a method for manufacturing a photodetection device according to a third aspect of the present disclosure, a transfer film is patterned in accordance with arrangement of a plurality of protrusions formed on a microlens of a pixel, and the plurality of protrusions on the microlens is formed by performing entire surface etching.

In the third aspect of the present disclosure, the transfer film is patterned in accordance with the arrangement of the plurality of protrusions formed on the microlens of the pixel, and the plurality of protrusions on the microlens is formed by performing entire etching.

The photodetection device and the electronic device may be independent devices or may be modules incorporated in another device.

BRIEF DESCRIPTION OF DRAWINGS

Fig. 1 is a block diagram illustrating a schematic configuration of a photodetection device to which the technology of the present disclosure is applied.
Fig. 2 is a plan view of the photodetection device of Fig. 1.
Fig. 3 is a cross-sectional view of the photodetection device of Fig. 1.
Fig. 4 is a cross-sectional view of a pixel section of the lens layer according to a first configuration example.

Fig. 5 is a plan view of a pixel section in Fig. 4.

Fig. 6 is a cross-sectional view of a peripheral portion of the lens layer according to the first configuration example.

Fig. 7 is a diagram illustrating a calculation example of a pitch of protrusions in a case where the medium is air.

Fig. 8 is a diagram illustrating a calculation example of a pitch of protrusions in a case where the medium is a fluorosiloxane resin.

Fig. 9 is a diagram illustrating a calculation example of heights of protrusions.

Fig. 10 is a diagram illustrating examination results of a gap between protrusions.

Fig. 11 is a diagram illustrating examination results of oblique incidence characteristics of sensitivity.

Fig. 12 is a view illustrating a method of manufacturing a lens structure of the first configuration example.

Fig. 13 is a plan view of a pixel section of a lens layer according to a second configuration example.

Fig. 14 is a plan view of a pixel section of a lens layer according to the second configuration example.

Fig. 15 is a plan view of a pixel section of a lens layer according to a third configuration example.

Fig. 16 is a plan view of a pixel section of a lens layer according to a fourth configuration example.

Fig. 17 is a cross-sectional view of a pixel section of a lens layer according to a fifth configuration example.

Fig. 18 is a cross-sectional view of a pixel section of a lens layer according to a sixth configuration example.

Fig. 19 is a plan view for explaining a lens layer according to a seventh configuration example.

Fig. 20 is a cross-sectional view of a pixel section of a lens layer according to an eighth configuration example.

Fig. 21 is a cross-sectional view of a pixel structure in which one microlens is shared by a plurality of pixels.

Fig. 22 is a cross-sectional view of a pixel section of a lens layer according to a ninth configuration example.

Fig. 23 is a cross-sectional view and a plan view of a pixel section of a lens layer according to a tenth configuration example.

Fig. 24 is a cross-sectional view of a pixel section of a lens layer according to the tenth configuration example.

Fig. 25 is a plan view of a pixel section of a lens layer according to the tenth configuration example.

Fig. 26 is a view illustrating a lens layer according to an eleventh configuration example.

Fig. 27 is a view illustrating a lens layer according to a twelfth configuration example.

Fig. 28 is a view illustrating a lens layer according to the twelfth configuration example.

Fig. 29 is a diagram illustrating a usage example of an image sensor.

Fig. 30 is a block diagram illustrating a configuration example of an imaging device as an electronic device to which the technology of the present disclosure is applied.

Fig. 31 is a block diagram depicting an example of schematic configuration of a vehicle control system.

Fig. 32 is a diagram of assistance in explaining an example of installation positions of an outside-vehicle information detecting section and an imaging section.

MODE FOR CARRYING OUT THE INVENTION

Hereinafter, modes for carrying out the technique of the present disclosure (hereinafter referred to as embodiments) will be described with reference to the accompanying drawings. Note that the description is given in the following order.

1. Schematic configuration example of photodetection device
2. Plan view of photodetection device
3. Cross-sectional view of photodetection device
4. Lens structure of first configuration example
5. Description of optimal pitch/height/gap of protrusions
6. Method of manufacturing lens structure of first configuration example
7. Lens structure of second configuration example
8. Lens structure of third configuration example
9. Lens structure of fourth configuration example
10. Combinations of first to fourth configuration examples
11. Lens structure of fifth configuration example
12. Lens structure of sixth configuration example
13. Lens structure of seventh configuration example
14. Lens structure of eighth configuration example
15. Lens structure of ninth configuration example
16. Lens structure of tenth configuration example
17. Lens structure of eleventh configuration example
18. Lens structure of twelfth configuration example
19. Usage example of image sensor
20. Example of application to electronic device
21. Example of application to mobile object

In the drawings referred to in the following description, the same or similar parts are denoted by the same or similar reference signs, and redundant description will be omitted as appropriate. The drawings are schematic, and the relationship between the thickness and the plane dimension, the ratio of the thickness of each layer, and the like are different from the actual ones. Furthermore, the drawings may include portions having different dimensional relationships and ratios.

Furthermore, the definitions of directions such as up and down or the like in the following description are merely definitions for convenience of description, and do not limit the technical idea of the present disclosure. For example, when an object is observed by rotating the object by 90°, the up and down are converted into and read as left and right, and when the object is observed by rotating the object by 180°, the up and down are inverted and read.

<1. Schematic configuration example of photodetection device>

Fig. 1 is a block diagram illustrating a schematic configuration of a photodetection device to which the technology of the present disclosure is applied.

The photodetection device 1 includes a pixel section 11, a vertical drive section 12, a column processing section 13, a horizontal drive section 14, a system control section 15, and the like. The vertical drive section 12, the column processing section 13, the horizontal drive section 14, the system control section 15, and the like are formed in a peripheral portion 19 (Fig. 2) outside the pixel section 11.

The photodetection device 1 further includes a signal processing section 16 and a data storage section 17. The signal processing section 16 and the data storage section 17 may be mounted on the same substrate as the pixel section 11, the vertical drive section 12, and the like, or may be disposed on another substrate. In addition, each processing of the signal processing section 16 and the data storage section 17 may be executed by an external signal processing section provided in a semiconductor chip different from the photodetection device 1, for example, a digital signal processor (DSP) circuit or the like.

The pixel section 11 has a configuration in which pixels 21 each including a photoelectric conversion section that generates and accumulates a charge according to the amount of received light are arranged in a matrix in a row direction and a column direction. Here, the row direction refers to a pixel row of the pixel section 11, that is, an array direction in the horizontal direction, and the column direction refers to a pixel column of the pixel section 11, that is, an array direction in a vertical direction.

Furthermore, in the pixel section 11, a pixel drive wiring 22 as a row signal line is wired along the row direction for each pixel row, and a vertical signal line 23 as a column signal line is wired along the column direction for each pixel column. The pixel drive wiring 22 transmits a drive signal for driving when reading a signal from the pixel 21. In Fig. 1, the pixel drive wiring 22 is illustrated as one line, but the number is not limited to one. One end of the pixel drive wiring 22 is connected to an output terminal corresponding to each row of the vertical drive section 12.

The vertical drive section 12 includes a shift register and an address decoder, and drives the pixels 21 of the pixel section 11 at the same time for all the pixels or in units of rows or the like. The vertical drive section 12 constitutes a drive section that controls the operation of each pixel 21 of the pixel section 11 together with the system control section 15. Although a specific configuration of the vertical drive section 12 is not illustrated, the vertical drive section generally includes two scanning systems of a reading scanning system and a sweeping scanning system.

In order to read a signal from the pixel 21, the reading scanning system sequentially selects and scans the pixel 21 of the pixel section 11 row by row. The signal read from the pixel 21 is an analog signal. The sweeping scanning system performs sweep scanning on a read row on which the read scanning is to be performed by the reading scanning system earlier than the read scanning by an exposure time.

By the sweep scanning by the sweeping scanning system, unnecessary charges are swept out from the photoelectric conversion sections of the pixels 21 in the read row, whereby the photoelectric conversion sections of the respective pixels 21 are reset. Then, by sweeping out (resetting) unnecessary charges by the sweeping scanning system, a so-called electronic shutter operation is performed. Here, the electronic shutter operation refers to operation of discharging the charge of the photoelectric conversion section and newly starting exposure (starting accumulation of charges).

The signal read by the read operation of the reading scanning system corresponds to the amount of the received light after the immediately preceding read operation or electronic shutter operation. Then, the period from the read timing by the immediately preceding read operation or the sweep timing by the electronic shutter operation to the read timing by the current read operation is the exposure period in the pixel 21.

The signal output from each pixel 21 of the pixel row selectively scanned by the vertical drive section 12 is input to the column processing section 13 through each of the vertical signal lines 23 for each pixel column. The column processing section 13 performs predetermined signal processing on the signal output from each pixel 21 of the selected row through the vertical signal line 23 for each pixel column of the pixel section 11, and temporarily holds the pixel signal after the signal processing.

Specifically, the column processing section 13 performs, as signal processing, at least noise removal processing, for example, correlated double sampling (CDS) processing or double data sampling (DDS) processing. For example, in the CDS processing, fixed pattern noise unique to the pixel, such as reset noise or threshold variation of an amplification transistor in the pixel, is removed. The column processing section 13 may have, for example, an analog-digital (AD) conversion function in addition to the noise removal processing, and convert an analog pixel signal into a digital signal and output the digital signal.

The horizontal drive section 14 includes a shift register, an address decoder, and the like, and sequentially selects a unit circuit corresponding to the pixel column in the column processing section 13. When the selective scanning is performed by the horizontal drive section 14, the pixel signal subjected to the signal processing for every unit circuit in the column processing section 13 is sequentially output.

The system control section 15 includes a timing generator that generates various timing signals and the like, and performs drive control of the vertical drive section 12, the column processing section 13, the horizontal drive section 14, and the like on the basis of various timings generated by the timing generator.

The signal processing section 16 has at least an arithmetic processing function, and performs various signal processing such as arithmetic processing on the pixel signal output from the column processing section 13. The data storage section 17 temporarily stores data necessary for signal processing in the signal processing section 16. The pixel signal subjected to the signal processing in the signal processing section 16 is converted into a predetermined format and output from an output section 18 to the outside of the device.

The photodetection device 1 configured as described above generates a signal corresponding to the amount of received light of each pixel 21 of the pixel section 11 and outputs the signal to the outside. The photodetection device 1 can constitute, for example, a solid-state imaging device that detects a distribution of the amount of incident light of infrared light or visible light and captures the distribution as an image, or a light receiving device of a distance measuring system that receives infrared light and measures a distance to a subject by a direct ToF method or an indirect ToF method.

<2. Plan view of photodetection device>

Fig. 2 is a plan view of the photodetection device 1.

The pixel section 11 is formed in a central portion of a planar region of the entire photodetection device 1, and the peripheral portion 19 in which the vertical drive section 12, the column processing section 13, the horizontal drive section 14, and the like are formed is formed outside the pixel section 11. A plurality of pads 25 serving as electrical connection parts with the outside is formed in the peripheral portion 19.

<3. Cross-sectional view of photodetection device>

Fig. 3 is a cross-sectional view corresponding to a line segment X-X' in the plan view of Fig. 2, and is a cross-sectional view of the vicinity of the boundary between the pixel section 11 and the peripheral portion 19.

The photodetection device 1 is formed using a semiconductor substrate 51 using, for example, silicon (Si) as a semiconductor. In the pixel section 11, a photodiode 52, which is a photoelectric conversion section that photoelectrically converts incident light and generates a signal charge, is formed for each pixel 21. Although not illustrated, a pixel isolation portion in which a metal member or the like is embedded in a trench dug in the substrate depth direction is formed between the photodiodes 52 of pixels 21, and the photodiodes 52 of the pixels 21 are electrically isolated. Note that the material of the semiconductor substrate 51 may be, for example, a group IV semiconductor such as Ge or a group III-V semiconductor such as GaAs, InP, or InGaAs other than Si described above. In addition, the example of Fig. 3 is an example in which one semiconductor substrate 51 is used, but a plurality of semiconductor substrates may be stacked to form a stacked substrate.

In Fig. 3, an antireflection film/protection film 53, a light shielding film 54, a planarization film 55, a color filter layer 56, and a lens layer 57 are formed on the upper surface of the semiconductor substrate 51 in order from a lower layer to an upper layer.

The antireflection film/protection film 53 formed on an upper surface of the semiconductor substrate 51 is a laminated film of an antireflection film and a protection film. As the material of the antireflection film, for example, $HfO_2$, $Al_2O_3$, $Ta_2O_5$, $TiO_2$, or the like can be used, and as the material of the protection film, for example, $SiO_2$, SiON, or the like can be used.

The light shielding film 54 formed on the antireflection film/protection film 53 is formed at a boundary portion with an adjacent pixel in the pixel section 11, and is formed on the entire surface of the antireflection film/-protection film 53 in the peripheral portion 19. The light shielding film 54 can be formed using, for example, a metal material such as W, Ti, TiN, Ta, TaN, Al, or Cu. The same material as that of the upper planarization film 55 is embedded inside the light shielding film 54 of each pixel 21 of the pixel section 11. The light shielding film 54 of the pixel section 11 has an effect of suppressing color mixing, and a low refractive index film such as $SiO_2$ can be used instead of a film of a metal material.

The planarization film 55 is formed, for example, by spin-coating an organic material such as a resin. In addition, the planarization film 55 may be formed by forming, for example, an inorganic film such as $SiO_2$ and planarizing the film by chemical mechanical polishing (CMP). The planarization film 55 can be omitted.

On the planarization film 55, the color filter layer 56 that transmits light of any of red (R), green (G), and blue (B) wavelengths is formed for each pixel. The color filter layer 56 is formed by spin coating of photosensitive resin containing pigments such as colorant and dye, for example. In Fig. 3, for convenience of description, three colors of red (R), green (G), and blue (B) are sequentially arranged in one row or one column, but in a case where each color of red (R), green (G), and blue (B) is arranged by, for example, a Bayer array, one row or one column is an array of two colors of red and green or green and blue. The array of the color filter layer 56 may be an array method other than the Bayer array, or may be an array of other colors such as yellow (Ye), cyan (Cy), and clear (C).

The lens layer 57 formed using an organic resin or an inorganic film containing Si is formed on an upper surface of the color filter layer 56. In the pixel section 11 of the lens layer 57, a microlens 61 that condenses incident light on the photodiode 52 is formed in units of pixels. On the other hand, the microlens 61 is not formed in the peripheral portion 19, and the lens layer 57 is formed flat.

In the photodetection device 1 configured as described above, light enters the microlens 61 from the upper side of Fig. 3, passes through the color filter layer 56 and the like, enters the photodiode 52 of each pixel 21, and is photoelectrically converted. The upper surface of the semiconductor substrate 51 on which the lens layer 57, the color filter layer 56, and the like are formed is a back surface side of the semiconductor substrate 51, and a multilayer wiring layer (not illustrated in Fig. 3) including a plurality of wiring layers and an interlayer insulating film is formed on a lower side of the semiconductor substrate 51 on a front surface side. Therefore, the photodetection device 1 of Fig. 3 is a back-illuminated photodetection device in which light is incident from the back surface side of the semiconductor substrate 51.

Note that the photodetection device 1 can also be configured as a surface irradiation type in which light is incident from the front surface side of the semiconductor substrate 51.

Although not illustrated in Fig. 3, the photodetection device 1 is characterized in that a protrusion is formed on an upper portion of the microlens 61 to improve a light condensing effect and improve optical characteristics. Hereinafter, the lens layer 57 of the photodetection device 1 will be illustrated in an enlarged manner, and details of a lens structure of the photodetection device 1 will be described.

Hereinafter, a structure of the lens layer 57 of the pixel section 11 or the peripheral portion 19 will be described, but for simplicity, regardless of the pixel section 11 or the peripheral portion 19, the lens structure will be described as the lens structure of a first configuration example to a twelfth configuration example.

<4. Lens structure of first configuration example>

First, a lens structure of the first configuration example will be described.

Fig. 4 is an enlarged cross-sectional view of the lens layer 57 of the pixel section 11 in the lens structure of the first configuration example. Fig. 4 illustrates a cross-sectional view of pixel sections 11 corresponding to two pixels arranged in the row direction or the column direction.

In the lens layer 57 of the pixel section 11, the microlens 61 and a plurality of protrusions 62 formed on an upper surface of the microlens 61 are formed in units of pixels 21. The microlens 61 is formed by a predetermined curved surface, and the protrusions 62 include the same material as the microlens 61 along a curved surface of the microlens 61. The materials of the microlens 61 and the protrusions 62 can be, for example, organic resin, Si, SiN, SiO2, SiON, or a combination thereof. An antireflection film may be formed on the upper surfaces of the microlens 61 and the plurality of protrusions 62. The microlens 61 including the protrusions 62 condenses incident light on the photodiode 52 which is a photoelectric conversion section.

On the upper surface of the microlens 61, two or more protrusions 62 of which at least one of a width W, a height H, or a density $\rho$ (not illustrated) is different are formed. The width W of the protrusion 62 is a length in the planar direction of the protrusion 62, and the height H is a length in the vertical direction from the curved surface to a distal end of the microlens 61. When a period in the planar direction of the plurality of protrusions 62 formed on the upper surface of the microlens 61 is a pitch d, and a width between the protrusions 62 where the protrusions 62 are not formed and the microlens 61 is exposed is a gap G, the pitch d is equal to the sum of the width W and the gap G of the protrusions 62 ($d = W + G$). The density $\rho$ of the protrusions 62 is determined by the pitch d and the width W of the protrusions 62. Note that the height H varies depending on where the bottom portion is taken, but here, the height obtained by averaging orientation dependence is defined as the height of the protrusion 62.

The protrusion 62 has, for example, a shape that becomes thinner toward the distal end (zenith), and is configured in, for example, a cone shape. The line segment connecting the distal end and the bottom portion of the protrusion 62 in the cross-sectional view is not limited to a straight line, and may be a curved line. The three-dimensional shape of the protrusion 62 may be a parabolic shape of a curved surface in which a line segment connecting the distal end and the bottom portion is recessed inward in the cross-sectional view, or a bell shape of a curved surface bulging outward.

Among the plurality of protrusions 62 formed on the upper surface of the microlens 61, the height h2 of the protrusion 62 in a peripheral portion of the microlens 61 is formed lower than the height h1 of the protrusion 62 in a central portion. That is, as illustrated in Fig. 4, when a curvature radius of the curved surface connecting the distal ends of the protrusions 62 is Ra and a curvature radius of the microlens 61 is Rb, the relationship of $Ra < Rb$ is established. For example, the height h2 of the protrusion 62 in the peripheral portion of the microlens 61 is equal to or less than 95% of the height h1 of the protrusion 62 in the central portion. The height H of the protrusion 62 may gradually change from the central portion toward the peripheral portion of the microlens 61. Note that, in general, in a single pixel having a pixel size smaller than 10 $um^2$, a state in which the height of the protrusion 62 differs by 5% or more due to manufacturing variations of the semiconductor process does not occur.

Fig. 5 is a plan view of the pixel section 11 illustrated in Fig. 4. Note that, in the plan view of Fig. 5, the protrusions 62 are denoted with density in order to facilitate distinction.

As illustrated in Fig. 5, the protrusions 62 are arranged in a square array in the pixel 21. That is, the plurality of protrusions 62 is linearly arranged at the same position in the row direction and the column direction at equal pitches. However, the method of arranging the protrusions 62 is not limited thereto, and the plurality of protrusions 62 arranged at equal pitches in the row direction and the column direction may be arranged like a hexagonal close-packed structure in which the protrusions are arranged at positions shifted by a half pitch from other adjacent arrangements in the row direction and the column direction.

The pixel 21 is formed by a rectangular region, and a pixel boundary portion 63 outside the microlens 61 of each pixel 21 is formed flat. The protrusions 62 are formed not only on the microlens 61 formed by a curved surface but also on the pixel boundary portion 63.

The arrangement, height H, and width W of the protrusion 62 in the pixel 21 may be the same in all the pixels 21 in the pixel section 11, or may be different depending on the position in the pixel section 11. In addition, there may be a pixel 21 in which the protrusion 62 is not formed and only the microlens 61 is formed in a part of the plurality of pixels 21 arranged in the pixel section 11.

Fig. 6 is an enlarged cross-sectional view of the lens layer 57 of the peripheral portion 19 in the lens structure of the first configuration example.

In the description of Fig. 3, it has been described that the lens layer 57 of the peripheral portion 19 is formed flat, but the microlens 61 is not formed in the peripheral portion 19, but the protrusions 62 is periodically formed. The pitch d, the width W, the gap G, and the height H of the protrusion 62 of the peripheral portion 19 may be the same as or different from those of the protrusions 62 of the pixel section 11.

## <5. Description of optimal pitch/height/gap of protrusions>

Next, an optimal pitch d, gap G, and height H of the protrusion 62 will be described.

First, the pitch d of the protrusions 62 will be described.

With respect to the pitch d of the protrusions 62, in a case where the protrusions 62 are periodically arranged, the periodically arranged protrusions 62 act as a diffraction grating, and transmitted light diffracted at a high order becomes a stray light component, which may deteriorate crosstalk and cause a decrease in sensitivity. In order to avoid this high-order diffraction phenomenon, the pitch d of the protrusions 62 is set to have the following relational expression (1) with respect to a refractive index n1 of the microlens 61, a refractive index n2 of a medium above the microlens 61, an assumed wavelength λ of the incident light, and an angle θ (incident angle θ) of the incident light.

$$d < \lambda/(n1 + n2 \times \sin\theta) \quad ..... \quad (1)$$

In a case where the pitch d of the protrusions 62 satisfies the relational expression (1), theoretically, the high-order diffraction does not occur, and only a zeroth-order component of the incident light is transmitted.

Fig. 7 illustrates an example of the pitch d of the protrusions 62 satisfying the relational expression (1) in a case where the medium above the microlens 61 is air (refractive index n2 = 1.0) and the material of the microlens 61 is SiN, an acrylic styrene resin, or amorphous Si (amorphous silicon).

The table illustrated in Fig. 7 is calculated for a total of four kinds of wavelengths in which the wavelength λ of incident light is set to an average value and a lower limit value of visible light, and two target wavelengths of infrared light. The refractive index n1 of the microlens 61 is a value corresponding to the wavelength λ of the incident light. The average value of the visible light is calculated for a case where the incident angle θ is 0 degrees, and the lower limit value of the visible light and the two target wavelengths of the infrared light are calculated for cases where the incident angle θ is 0 degrees and -90 degrees.

The upper side of the microlens 61 may be filled with resin instead of air.

Fig. 8 illustrates an example of the pitch d of the protrusions 62 satisfying the relational expression (1) in a case where the medium above the microlens 61 is a fluorosiloxane resin (refractive index n2 = 1.41). The material of the microlens 61 and the wavelength λ of the incident light are similar to those in Fig. 7.

The pitch d of the protrusions 62 varies depending on the target wavelength λ and the incident angle θ of the incident light, but as is apparent with reference to the calculation results of Figs. 7 and 8, the pitch d of the protrusions 62 has an uneven structure smaller than the target wavelength λ of the incident light.

Next, the height H of the protrusion 62 will be described.

Fig. 9 illustrates a result of calculating the height H of the protrusion 62 for each wavelength λ of the incident light with reflectance of 0.7% or less at the interface of the microlens 61 as a target.

A solid line graph indicates a calculation result of the height H in a case where the medium above the microlens 61 is air and the material of the microlens 61 and the protrusions 62 is SiN.

A broken line graph indicates a calculation result of the height H in a case where the medium above the microlens 61 is air and the materials of the microlens 61 and the protrusions 62 are acrylic styrene resin.

A graph of an alternate long and short dash line shows a calculation result of the height H in a case where the medium above the microlens 61 is a fluorosiloxane resin and the material of the microlens 61 and the protrusions 62 is SiN.

Although the height H of the protrusion 62 depends on the combination of materials, it can be seen that the height H is a substantially linear monotonic increase with respect to the wavelength λ of the incident light in any material. From this calculation result, it is sufficient if the height H of the protrusion 62 is formed to be at least 100 nm or more, preferably 200 nm or more. Note that, in a case where a bottom portion is lower than the distal end of the microlens 61 in processing the protrusions 62 on the curved surface of the microlens 61, it has been found that there is no problem as long as the number of protrusions 62 equal to or more than half of the number of protrusions on the microlens 61 satisfies the above criteria of the height H.

Next, the gap G between the protrusions 62 will be described.

Fig. 10 illustrates results of calculating reflectance for parallel light of five kinds of wavelengths while setting the gap G between the protrusions 62 to "large gap", "medium gap", and "no gap". Furthermore, reflectance in a case where, as "comparative structure 1", a SiO2 film having a film thickness of 100 nm is formed as the antireflection film without forming the protrusions 62 on the microlens 61 is also illustrated. Note that the pixel size of the pixel 21 was 1.44 um square, and conditions other than the gap G were common. As specific common conditions, the material of the microlens 61 is an acrylic styrene-based resin, the medium above the microlens 61 is air, the pitch d of the protrusions 62 is 240 nm, and the height H of the protrusions 62 is 480 nm.

In general, the shape of the protrusion 62 is ideally a bell shape (moth-eye shape), and it is said that it is preferable to eliminate the flat portion as much as possible. However, referring to the calculation results of Fig. 10, the reflectance is significantly improved compared to the "comparative structure 1" by providing the protrusions 62, but the dependency of the gap G tends to be weak. This is because the gap G formed between the bottom portions of the protrusions 62 has an effect of scattering light due to the curvature of the microlens 61 as a base. Therefore, the magnitude of the gap G does not significantly affect the reflectance.

Next, oblique incidence characteristics of sensitivity will be described.

Fig. 11 illustrates a calculation result of the oblique incidence sensitivity characteristic when the incident angle θ is changed.

Fig. 11 illustrates results of the oblique incidence sensitivity characteristic when the incident angle θ is distributed for five structures of a case where the gap G between the protrusions 62 is "large gap", "medium gap", and "no gap", a case where the antireflection film is not formed as a comparative structure (comparative structure A), and a case where the SiO2 film having a film thickness of 100 nm is formed as the antireflection film (comparative structure B). Each structure is based on the sensitivity when the incident angle θ = 0 degrees.

According to the result of Fig. 11, a tendency of gap dependence is remarkably shown in the oblique incidence sensitivity in the vicinity of the incident angle θ = 20 degrees. This gap dependence is because when the gap G between the protrusions 62 is narrow, condensing power due to a shape effect of the curved surface of the microlens 61 is weakened and the incident light is spread, and is reflected by the light shielding film arranged between the pixels. From these data, it is found that it is better to have a certain degree of gap between the protrusions 62 from the viewpoint of oblique incidence sensitivity.

As a result of analysis including the results of Figs. 10 and 11, the gap G between the protrusions 62 is preferably equal to or more than 0.2 of the pitch d, and preferably equal to or more than 0.3 or more.

Note that, when moth-eye processing for forming the plurality of protrusions 62 on the curved surface of the microlens 61 is performed, gap variation occurs in the same pixel due to a processing conversion difference of dry etching or light proximity effect correction of lithography. Such variations in the gap at the bottom portion of the protrusion 62 have also been examined, but the influence is small even if a small part of the protrusion 62 does not satisfy the above criteria, and there is no problem as long as the number of protrusions 62 that is half or more of the number on the microlens 61 satisfies the above criteria.

With the lens structure of the first configuration example described above, in the pixel section 11, the uneven structure (moth-eye structure) is formed by forming a plurality of protrusions 62 smaller than the wavelength of the incident light on the microlens 61 formed in units of the pixels 21. Thus, an effective change in refractive index when light enters the microlens 61 becomes gentle, and an effect of reducing reflection on the surface of the microlens 61 can be obtained.

Furthermore, with the lens structure of the first configuration example, since the effective curvature of the microlens 61 including the protrusions 62 is smaller than that of only the microlens 61 in which the protrusions 62 are not formed, it is possible to enhance the lens power of the microlens 61 in which the protrusions 62 are formed. By forming the plurality of protrusions 62 on the microlens 61, the light condensing effect of the microlens 61 can be improved in units of pixels, and optical characteristics can be improved.

Moreover, by forming the protrusions 62 also in the lens layer 57 of the peripheral portion 19, it is possible to improve flare and ghost due to reflected light from the peripheral portion 19.

<6. Method of manufacturing lens structure of first configuration example>

Next, a method of manufacturing a pixel section of the lens structure of the first configuration example will be described with reference to Fig. 12.

First, as illustrated in A of Fig. 12, a lens material 81 is formed on the upper surface of the color filter layer 56 (not illustrated) by, for example, a PE-CVD method. In Fig. 12, the lens material 81 is SiN.

Next, as illustrated in B of Fig. 12, a resist mask 82 is patterned by lithography and then reflowed by heat treatment, whereby the resist mask 82 is deformed into a lens shape.

Next, as illustrated in C of Fig. 12, the entire surface is subjected to plasma etching, whereby the lens shape of the resist mask 82 is transferred to the lens material 81.

Next, as illustrated in D of Fig. 12, a transfer film 83 different from the lens material 81 is formed on the lens material 81 by using, for example, a PE-CVD method, a PE-PVD method, or the like. In a case where the lens material 81 is SiN, the material of the transfer film 83 is preferably a material capable of obtaining a selection ratio of plasma etching to SiN, such as SiO2, SiCO, SiCN, Ti, TiN, Ta, TaN, Al2O3, Ta2O5, or TiO2. In the PE-CVD method and the PE-PVD method, since the film formation coverage is smaller than 1, a film thickness of the transfer film 83 is thinner at a bottom portion than at an upper portion of the lens material 81 having a lens shape.

Next, as illustrated in E of Fig. 12, a planarizing material 84 such as SOC (spin-on carbon) is applied onto the transfer film 83, and then an SOG (spin-on glass) 85 is formed. Moreover, a resist mask 86 is patterned by lithography at a portion on the SOG85 where the protrusions 62 are to be formed.

Next, as illustrated in F of Fig. 12, the transfer film 83 is patterned using plasma etching on the basis of the patterned resist mask 86.

Finally, as illustrated in G of Fig. 12, the transfer film 83 is transferred to the lens material 81 by performing plasma etching on the entire surface. Thus, the lens material 81 is formed in the microlens 61 and the protrusions 62. The height of the protrusion 62 is determined by the thickness of the transfer film 83 and the selection ratio of plasma etching, but since the film thickness of the transfer film 83 is thin at the bottom portion of the lens material 81, the relationship between a curvature radius Ra of a curved surface connecting the distal ends of the protrusions 62 and a curvature radius Rb of the microlens 61 is Ra < Rb. Furthermore, the distal end of the protrusion 62 becomes thinner than the bottom portion due to angle dependence of an etching yield.

As described above, the microlens 61 and the protrusions 62 can be formed by patterning the transfer film 83 in accordance with the arrangement of the protrusions 62 and etching the entire surface. Furthermore, by making the film thickness of the transfer film 83 thinner at the bottom portion than at the upper portion of the microlens 61, the curvature radius Ra of the curved surface connecting the distal ends of the protrusions 62 can be made smaller than the curvature radius Rb of the microlens 61 (Ra < Rb).

## <7. Lens structure of second configuration example>

Next, a lens structure of the second configuration example will be described.

In the second to twelfth lens structures described below, portions different from the lens structure of the first configuration example described with reference to Figs. 5 to 6 will be described, and common portions will be appropriately omitted.

Fig. 13 is a plan view of the lens layer 57 of the pixel section 11 in the lens structure of the second configuration example. Also in Fig. 13, similarly to the first configuration example in Fig. 5, a plan view for two pixels is illustrated.

In the first configuration example illustrated in Fig. 5, the protrusions 62 formed on the upper surface of the microlens 61 and the protrusions 62 formed in the pixel boundary portion 63 have the same width W, height H, and density $\rho$ of the protrusions 62.

On the other hand, in the second configuration example of Fig. 13, the protrusions 62 formed on the upper surface of the microlens 61 and the protrusions 62 formed in the pixel boundary portion 63 are formed so that the width W, the height H, and the density $\rho$ of the protrusions 62 are different. More specifically, the protrusions 62 formed in the pixel boundary portion 63 are formed so that the width W, the height H, and the density $\rho$ of the protrusions 62 are narrower than those of the protrusions 62 formed on the upper surface of the microlens 61. The density $\rho$ of the protrusions 62 may change the pitch d or the width W.

In a case where the width W, the height H, and the density $\rho$ of the protrusions 62 are formed to be narrow, low, and small, respectively, the effective refractive index of the lens decreases. By forming the protrusions 62 of the pixel boundary portion 63 so that the width W, the height H, and the density $\rho$ of the protrusions 62 are narrower than those of the protrusions 62 on the upper surface of the microlens 61, the lens power of the pixel boundary portion 63 is increased, and the light of the pixel boundary portion 63 can be efficiently guided to the photodiode 52 that is a photoelectric conversion section.

As a structure in which the lens power of the pixel boundary portion 63 is further increased, as illustrated in Fig. 14, the protrusions 62 may not be formed in the pixel boundary portion 63.

For all of the width W, the height H, and the density $\rho$ of the protrusions 62, the protrusions 62 of the pixel boundary portion 63 may be thinner, lower, and smaller than the upper surface of the microlens 61, or any one or two of the width W, the height H, and the density $\rho$ may be thinner, lower, and smaller.

Also in the lens structure of the second configuration example, by forming the plurality of protrusions 62 on the microlens 61, the light condensing effect of the microlens 61 can be improved in units of pixels, and the optical characteristics can be improved.

## <8. Lens structure of third configuration example>

Next, a lens structure of the third configuration example will be described.

Fig. 15 is a plan view of the lens layer 57 of the pixel section 11 in the lens structure of the third configuration example. Also in Fig. 15, similarly to the first configuration example in Fig. 5, a plan view for two pixels is illustrated.

In the first configuration example illustrated in Fig. 5, the protrusions 62 are formed on both the upper surface of the microlens 61 and the pixel boundary portion 63.

On the other hand, in the third configuration example of Fig. 15, the plurality of protrusions 62 is formed on the microlens 61, but the protrusions 62 are not formed in the pixel boundary portion 63. Furthermore, the width W of the protrusion 62 formed on the microlens 61 is different between the central portion and the peripheral portion of the microlens 61. Specifically, the width W of the protrusion 62 is formed to be narrower in the peripheral portion than in the central portion of the microlens 61. For example, the width W of the protrusion 62 at the central portion of the microlens 61 is set to 200 nm, the width W gradually changes from the central portion toward the peripheral portion of the microlens 61, and the width W of the protrusion 62 is formed to be 190 nm or less at the peripheral portion. Furthermore, according to the change in the width W, the height H of the protrusion 62 is also formed to be lower from the central portion toward the peripheral portion of the microlens 61. Moreover, since the width W and the height H are different, the density ρ is also formed to be smaller from the central portion toward the peripheral portion of the microlens 61. Note that, in general, in a single pixel having a pixel size smaller than 10 $um^2$, the width 62 of the protrusion 62 formed on the microlens 61 does not change by 5% or more due to manufacturing variations of the semiconductor process.

When the width W of the protrusion 62 decreases, the effective refractive index of the lens decreases. With the lens structure of the third configuration example in which the width W of the protrusion 62 is formed narrower in the peripheral portion than in the central portion of the microlens 61, the effective curvature of the microlens 61 including the protrusion 62 is smaller and the lens power can be increased as compared with the case where the width of the protrusion 62 is uniform.

Also in the lens structure of the third configuration example, by forming the plurality of protrusions 62 on the microlens 61, the light condensing effect of the microlens 61 can be improved in units of pixels, and the optical characteristics can be improved.

<9. Lens structure of fourth configuration example>

Next, a lens structure of the fourth configuration example will be described.

Fig. 16 is a plan view of the lens layer 57 of the pixel section 11 in the lens structure of the fourth configuration example. Also in Fig. 16, similarly to the first configuration example in Fig. 5, a plan view for two pixels is illustrated.

In the first configuration example illustrated in Fig. 5, the protrusions 62 are formed on both the upper surface of the microlens 61 and the pixel boundary portion 63.

On the other hand, in the fourth configuration example of Fig. 16, the plurality of protrusions 62 is formed on the microlens 61, but the protrusions 62 are not formed in the pixel boundary portion 63. Furthermore, the density ρ of the protrusions 62 formed on the microlens 61 is different between the central portion and the peripheral portion of the microlens 61. Specifically, the distance between the protrusions 62 formed on the microlens 61 is large in the peripheral portion, and the density ρ of the protrusions 62 is smaller in the peripheral portion than in the central portion of the microlens 61. The formation position of the protrusions 62 can be controlled by the formation position of the resist mask 86 by lithography in the process of E of Fig. 12 in the manufacturing process described with reference to Fig. 12.

When the density ρ of the protrusions 62 decreases, the effective refractive index of the lens decreases. With the lens structure of the fourth configuration example in which the density ρ of the protrusions 62 is formed to be smaller in the peripheral portion than in the central portion of the microlens 61, the effective curvature of the microlens 61 including the protrusions 62 is reduced and the lens power can be increased as compared with the case where the density ρ of the protrusions 62 on the microlens 61 is uniform.

Also in the lens structure of the fourth configuration example, by forming the plurality of protrusions 62 on the microlens 61, the light condensing effect of the microlens 61 can be improved in units of pixels, and the optical characteristics can be improved.

<10. Combinations of first to fourth configuration examples>

In the first configuration example illustrated in Fig. 5, the height H of the plurality of protrusions 62 on the microlens 61 is formed to change (decrease) from the central portion toward the peripheral portion of the microlens 61. The protrusions 62 are formed on both the microlens 61 and the pixel boundary portion 63 at the same pitch d (= width W+ gap G).

In the second configuration example of Figs. 13 and 14, at least one of the width W, the height H, and the density ρ of the protrusions 62 is different between the protrusions 62 formed on the upper surface of the microlens 61 and the protrusions 62 formed in the pixel boundary portion 63, or the protrusions 62 of the pixel boundary portion 63 is omitted.

In the third configuration example of Fig. 15, the width W, the height H, and the density ρ of the protrusions 62 formed on the microlens 61 are different between the central portion and the peripheral portion of the microlens 61, and change from the central portion toward the peripheral portion of the microlens 61.

In the fourth configuration example of Fig. 16, the density ρ of the protrusions 62 formed on the microlens 61 is different between the central portion and the peripheral portion of the microlens 61 by changing the distance between the protrusions 62 without changing the width W of the protrusions 62.

It is possible to employ a structure in which the structures of the protrusions 62 of the first to fourth configuration examples are arbitrarily combined, control the effective curvature of the microlens 61 including the protrusions 62, and adjust the lens power. For example, by combining the third configuration example of Fig. 15 and the fourth configuration example of Fig. 16 and making both the width W of the protrusions 62 formed on the microlens 61 and the distance between the protrusions 62 different between the central portion and the peripheral portion of the microlens 61, it is possible to enhance the lens power of the microlens 61 including the protrusions 62.

<11. Lens structure of fifth configuration example>

Next, a lens structure of the fifth configuration example will be described.

Fig. 17 is an enlarged cross-sectional view of the lens layer 57 of the pixel section 11 in the lens structure of the fifth configuration example. Fig. 17 illustrates a cross-sectional view of one pixel.

The protrusions 62 of the fifth configuration example of Fig. 17 is different from the first configuration example illustrated in Fig. 5 in that the distal end 101 has a shape inclined toward the center side of the microlens 61. In Fig. 17, the position of the distal end 101 of each protrusion 62 is located inside a bottom center 102 of the protrusions 62 (in a center direction of the microlens 61), and the distance between the distal end 101 and the bottom center 102 in the planar direction increases toward the peripheral portion of the microlens 61. The inclination amount of the distal end 101 of the protrusions 62 may be gradually increased toward the peripheral portion of the microlens 61 or may be the same. The position of the distal end 101 of the protrusion 62 at the center of the microlens 61 is the same as the bottom center 102 of the protrusions 62. Other configurations of the fifth configuration example are similar to those of the first configuration example.

By forming the distal ends 101 of the protrusions 62 formed on the upper surface of the microlens 61 to be inclined in the center direction of the microlens 61, the curvature radius Ra of the curved surface connecting the distal ends 101 of the protrusions 62 is reduced as compared with the case where the distal ends 101 of the protrusions 62 is at the bottom center 102, so that the lens power of the microlens 61 can be increased.

The fifth configuration example of Fig. 17 can be arbitrarily combined with the structure of the protrusions 62 of the first to fourth configuration examples described above.

Also in the lens structure of the fifth configuration example, by forming the plurality of protrusions 62 on the microlens 61, the light condensing effect of the microlens 61 can be improved in units of pixels, and the optical characteristics can be improved.

<12. Lens structure of sixth configuration example>

In the photodetection device 1, as the pixel 21 of the pixel section 11, there may be a configuration in which a normal pixel that is a pixel for video output and a phase difference pixel that is a pixel for focus detection are arranged. In Fig. 18, a configuration of the protrusions 62 in a case where the phase difference pixel is arranged will be described as a lens structure of the sixth configuration example.

Fig. 18 illustrates a cross-sectional view of each of the normal pixel and the phase difference pixel.

In the configuration below the color filter layer 56, the difference between the normal pixel and the phase difference pixel is that the light shielding film 54 formed on the antireflection film/protection film 53 is formed only at the pixel boundary in the normal pixel, whereas in the phase difference pixel, the light shielding film is formed so as to cover one half (the right half in Fig. 18) of the photodiode 52 in order to perform pupil division.

Regarding the protrusions 62 on the microlens 61, the protrusions 62 are formed so that the lens power of the phase difference pixel is stronger than that of the normal pixel by making at least one of the width W, the height H, and the density ρ of the protrusions 62 different between the normal pixel and the phase difference pixel.

The example of Fig. 18 illustrates an example in which the density ρ of the protrusions 62 is changed between the normal pixel and the phase difference pixel. Specifically, seven protrusions 62 are formed in the normal pixel, but five protrusions 62 are formed in the phase difference pixel, and two protrusions 62 in the peripheral portion are omitted as compared with the normal pixel. By omitting the two protrusions 62 in the peripheral portion, as indicated by a broken line, the condensing point of the phase difference pixel is changed to be closer to the front (closer to the microlens 61) than the normal pixel.

As described above, in a case where the normal pixel and the phase difference pixel are provided in the pixel section 11, by changing the configuration of the protrusions 62 between the normal pixel and the phase difference pixel, it is possible to collect light optimal for each of the normal pixel and the phase difference pixel, and it is possible to achieve both optical performance and autofocus performance. The adjustment of the lens power of the phase difference pixel compared to the normal pixel can be performed by appropriately combining the configurations of the protrusions 62 of the first to fifth configuration examples described above.

Also in the lens structure of the sixth configuration example, by forming the plurality of protrusions 62 on the microlens 61, the light condensing effect of the microlens 61 can be improved in units of pixels, and the optical characteristics can be improved.

## <13. Lens structure of seventh configuration example>

Next, as a lens structure of the seventh configuration example, not a difference in each protrusion 62 in the pixel but a difference in the configuration of the protrusions 62 in units of pixels will be described.

Fig. 19 is a plan view of the photodetection device 1 illustrated in Fig. 2.

Note that, in the following description, in order to describe the difference depending on the pixel position in the pixel section 11, the pixel position in the central portion of the pixel section 11 will be referred to as an image height center position, and the pixel position near the outer peripheral portion of the pixel section 11 will be referred to as a high image height position.

In the lens structure of the seventh configuration example, the protrusions 62 of each pixel 21 are formed so that the lens power of the microlens 61 including the protrusions 62 of each pixel 21 varies according to the distance from the center of the pixel section 11. Specifically, as illustrated in Fig. 19, the protrusions 62 of each pixel 21 are formed so that the lens power is weak in the pixel 21 close to the central portion of the pixel section 11 and the lens power increases toward the outer peripheral portion of the pixel section 11. The adjustment of the lens power may be performed by changing any of the width W, the height H, and the density ρ of the protrusions 62, and can be performed by appropriately combining the configurations of the protrusions 62 of the first to fifth configuration examples described above.

With the lens structure of the seventh configuration example, as compared with the case where the protrusions 62 have the same configuration in all the pixels of the pixel section 11, by changing the configuration of the protrusions 62 according to the pixel position of the pixel section 11, it is possible to improve the light condensing performance at the high image height position where the incident light is obliquely incident light. The amount of pupil correction in the pixel 21 at the high image height position can be reduced, and thus optical characteristics can be improved.

Also in the lens structure of the seventh configuration example, by forming the plurality of protrusions 62 on the microlens 61, the light condensing effect of the microlens 61 can be improved in units of pixels, and the optical characteristics can be improved.

## <14. Lens structure of eighth configuration example>

Also in a lens structure of the eighth configuration example, a difference in the configuration of the protrusions 62 depending on the pixel position in the pixel section 11 will be described.

Fig. 20 is an enlarged cross-sectional view of the lens layer 57 of the pixel section 11 in the lens structure of the eighth configuration example. Fig. 20 illustrates cross-sectional views of the microlens 61 and the protrusions 62 at each of the image height center position and the high image height position.

In the eighth configuration example, in the pixel 21 other than the image height center position, the protrusions 62 are formed so that the center (vertex) of the effective refractive index of the microlens 61 including the protrusions 62 is different from the center (vertex) of the microlens 61 not including the protrusions 62. The center (vertex) of the effective refractive index of the microlens 61 including the protrusions 62 is adjusted by at least one of the width W, the height H, and the density ρ of the protrusions 62.

In the example of Fig. 20, in the pixel 21 at the image height center position, a center (vertex) Xa1 of the effective refractive index of the microlens 61 including the protrusions 62 coincides with a center (vertex) Xb1 of the microlens 61 not including the protrusions 62.

On the other hand, in the pixel 21 at the high image height position, a center Xa2 of the effective refractive index of the microlens 61 including the protrusions 62 is different from a center Xb2 of the microlens 61 not including the protrusions 62. The center Xa2 of the effective refractive index of the microlens 61 including the protrusions 62 is shifted toward the center side of the pixel section 11 with respect to the center Xb2 of the microlens 61 not including the protrusions 62, and the protrusions 62 are formed so as to be asymptotically lower than the center Xa2.

The protrusions 62 are formed so that a deviation between the center Xa2 of the effective refractive index of the microlens 61 including the protrusion 62 and the center Xb2 of the microlens 61 not including the protrusions 62 becomes larger toward the outer peripheral portion according to the distance from the center of the pixel section 11.

The example of Fig. 20 is an example in which the center Xa2 of the effective refractive index of the microlens 61 including the protrusions 62 coincides with the vertex of the curved surface Ra2 connecting the distal ends of the protrusions 62 in the pixel 21 at the high image height position, but the center Xa2 of the effective refractive index of the microlens 61 including the protrusions 62 does not necessarily coincide with the vertex of the curved surface Ra2 connecting the distal ends of the protrusions 62. For example, even if the center of the curved surface Ra2 connecting the distal ends of the protrusions 62 is the same as the center Xb2 of the curved surface Rb2 of the microlens 61, the center of the effective refractive index including the protrusions 62 may be different from the center Xb2 of the curved surface Rb2 of the microlens 61 by, for example, changing the density ρ of the protrusions 62 on the left side and the right side of the cross section.

With the lens structure of the eighth configuration example, as compared with the case where the protrusions 62 have the same configuration in all the pixels of the pixel section 11, the center of the effective refractive index of the microlens 61 including the protrusions 62 is made different from the center of the microlens 61 not including the protrusions 62 according to the pixel position of the pixel section 11, whereby the light condensing performance at the high image height position where the incident light is obliquely incident light can be improved. The amount of pupil correction in the pixel 21 at the high image height position can be reduced, and thus optical characteristics can be improved.

Also in the lens structure of the eighth configuration example, by forming the plurality of protrusions 62 on the microlens 61, the light condensing effect of the microlens 61 can be improved in units of pixels, and the optical characteristics can be improved.

<15. Lens structure of ninth configuration example>

A lens structure of the ninth configuration example is a lens structure in the case of a pixel structure in which one microlens 61 is shared by a plurality of pixels.

Fig. 20 illustrates a cross-sectional view of a pixel structure in which 4 pixels of 2 × 2 share one microlens 61. In the case of such a pixel structure in which a plurality of pixels shares one microlens 61, both a pixel signal for video output and a phase difference signal for focus detection can be acquired. In such a pixel structure having both imaging performance and autofocus performance, it is important to optimize the spot size of light incident on the photodiode 52 as a photoelectric conversion section. However, since the distance from the microlens 61 to the light receiving surface (upper surface of the photodiode 52) is different between the central portion and the outer peripheral portion of the pixel section 11, the spot size of light changes in the case of the normal microlens 61 without the protrusions 62 as illustrated in Fig. 21. Specifically, the spot size at the high image height position is smaller than the spot size at the image height center position.

Fig. 22 is an enlarged cross-sectional view of the lens layer 57 of the pixel section 11 in the lens structure of the ninth configuration example. Fig. 22 illustrates cross-sectional views of the microlens 61 and the protrusions 62 at each of the image height center position and the high image height position.

At the image height center position, the microlens 61 and the plurality of protrusions 62 formed on the upper surface of the microlens 61 are formed in the same manner as in the first configuration example described above except that one microlens 61 is shared by a plurality of pixels. When a curvature radius of a curved surface connecting the distal ends of the protrusions 62 is represented by Ra3 and the curvature radius of the microlens 61 is represented by Rb3, a relationship of Ra3 < Rb3 is established.

On the other hand, at the high image height position, a recess is formed by the protrusions 62 in a region near the center of the microlens 61. This recess is formed by the pixels 21 other than the image height center position, but can be formed so as to increase toward the outer peripheral portion according to the distance from the center of the pixel section 11, for example. By making the width **W,** the height H, and the density ρ of the protrusions 62 in the region near the center of the microlens 61 different from the lens shape at the image height center position, the effective refractive index of the microlens 61 is formed to be low. In order to lower the effective refractive index of the microlens 61, the width W may be made thin, the height H may be made low, or the density ρ may be made small, but in the example of Fig. 22, the width W of the protrusions 62 is made thin and the height H is made low in the region near the center. When a curvature radius of a curved surface connecting the distal ends of the protrusions 62 is represented by Ra4 and the curvature radius of the microlens 61 is represented by Rb4, the relationship of Ra4 < Rb4 does not change.

With the lens structure of the ninth configuration example, in the pixel structure in which one microlens 61 is shared by a plurality of pixels, the recess by the protrusions 62 is formed to be large in the region near the center of the microlens 61 according to the distance from the center of the pixel section 11. Thus, the light incident on the region near the center of the microlens 61 can be diffused to expand the spot size, and the uniformity of the spot size of the light receiving surface at the central portion and the outer peripheral portion of the pixel section 11 can be improved.

Also in the lens structure of the ninth configuration example, by forming the plurality of protrusions 62 on the microlens 61, the light condensing effect of the microlens 61 can be improved in units of pixels, and the optical characteristics can be improved.

<16. Lens structure of tenth configuration example>

Next, a lens structure of the tenth configuration example will be described.

A of Fig. 23 is a cross-sectional view of one pixel of the lens layer 57 of the pixel section 11 in the lens structure of the tenth configuration example. B of Fig. 23 is a plan view of one pixel of the lens structure of the tenth configuration example.

In the tenth configuration example of Fig. 23, the plurality of protrusions 62 formed on the microlens 61 is formed to have a light diffraction/scattering structure having a size (subwavelength size scale) equivalent to the wavelength of the incident light. For example, in the cross-sectional view of A of Fig. 23, the protrusions 62 are formed in a serrated shape, and the protrusions 62 in a serrated shape are formed in a rectangular shape with rounded corners as a planar shape as illustrated in B of Fig. 23. In addition, as illustrated in Fig. 24, a light diffraction/scattering structure may be formed by a structure in which the protrusions 62 are provided by providing the concentric concave portion 62B.

With the lens structure of the tenth configuration example, the diffractive optical element performance can be imparted to the microlens 61. With the structure of the protrusions 62 in a serrated shape, correction of chromatic aberration, and the like are possible.

The light diffraction/scattering structure of the tenth configuration example may be combined with the protrusions 62 of the first to ninth configuration examples. For example, as illustrated in Fig. 25, a structure can be employed in which protrusions 62' in a serrated shape and the protrusions 62 of the first configuration example are combined.

In a case of being combined with the protrusions 62 of the first to ninth configuration examples, the light condensing effect of the microlens 61 can be improved in units of pixels, and the optical characteristics can be improved.

<17. Lens structure of eleventh configuration example>

Next, a lens structure of the eleventh configuration example will be described. The eleventh configuration example relates to a structure of the lens layer 57 in the peripheral portion 19 of the photodetection device 1.

A of Fig. 26 illustrates a plan view of the photodetection device 1 according to the eleventh configuration example, and B of Fig. 26 is a cross-sectional view of the lens layer 57 taken along line X-X' of the plan view of A of Fig. 26.

In the first configuration example described above, as described with reference to Fig. 6, the protrusions 62 is periodically formed in the peripheral portion 19.

On the other hand, in the eleventh configuration example, a flat region 151 in which the protrusions 62 are not formed is formed in a part of the peripheral portion 19. For example, as illustrated in the plan view of A of Fig. 26, the flat region 151 is formed in a rectangular shape so as to surround the pixel section 11 between the plurality of pads 25 arranged on each side of the rectangular peripheral portion 19 and the pixel section 11. The width of the flat region 151 on the line X-X' is formed to be, for example, about 10 to 100 um.

Note that, in the example of Fig. 26, the flat region 151 is formed in a rectangular shape so as to surround the pixel section 11, but the flat region 151 is not necessarily formed on all the four sides, and may be formed at a part of each side or at one or several positions of the entire chip.

With the eleventh configuration example, pickup of the photodetection device 1 as a semiconductor chip is facilitated as compared with a case where the protrusions 62 are formed in the entire region of the peripheral portion 19 as in the first configuration example.

<18. Lens structure of twelfth configuration example>

Next, a lens structure of the twelfth configuration example will be described. The twelfth configuration example relates to a structure of the lens layer 57 of the peripheral portion 19 in a case where the photodetection device 1 is a wafer level chip size package (CSP) downsized to a chip size.

Fig. 27 illustrates a cross-sectional view of the photodetection device 1 formed as a wafer level CSP.

A photodetection package 201 has a structure in which a transparent substrate (for example, a glass substrate) 212 is bonded to the upper side on the light incident surface side of the photodetection device 1 via an adhesive 211. On the lower side of the photodetection device 1, a plurality of solder balls 213 as external connection terminals to be electrically connected to an external substrate (not illustrated) is formed. The solder balls 213 are electrically connected to a wiring layer in the semiconductor substrate by, for example, a through silicon via (TSV).

As illustrated in the enlarged view on the right side of Fig. 27, a wall portion 221 that prevents the adhesive 211 from flowing into the pixel section 11 is formed in the lens layer 57.

A of Fig. 28 illustrates a plan view of the photodetection device 1 according to the twelfth configuration example, B of Fig. 28 illustrates an enlarged plan view of the lens layer 57 taken along line X-X' of A of Fig. 28, and C of Fig. 28 illustrates an enlarged cross-sectional view of the lens layer 57 taken along line X-X'.

For example, as illustrated in the plan view in A of Fig. 28, the wall portion 221 is formed in a rectangular shape so as to surround the pixel section 11 between the plurality of pads 25 arranged on each side of the rectangular peripheral portion 19 and the pixel section 11.

The width W' and the height H' of the wall portion 221 can be formed to be equal to or several times the width W and the height H of the protrusions 62 formed in the peripheral portion 19, but are preferably larger than the protrusions 62. In the example of Fig. 28, the wall portion 221 is formed in one linear shape, but may be formed in a plurality of linear shapes.

With the twelfth configuration example, since the wall portion 221 is formed, it is possible to prevent the adhesive 211 from flowing into the pixel section 11, and it is possible to suppress a defect caused by the adhesive 211 flowing into the pixel section 11.

<19. Usage example of image sensor>

Fig. 29 is a diagram illustrating a usage example in a case where the photodetection device 1 described above is used as an image sensor.

The above-described photodetection device 1 can be used as an image sensor in various cases of sensing light such as visible light, infrared light, ultraviolet light, and X-rays as described below, for example.

· A device that captures an image to be used for viewing, such as a digital camera and a portable device with a camera function.

· A device for traffic purpose such as an in-vehicle sensor which takes images of the front, rear, surroundings, interior and the like of an automobile, a surveillance camera for monitoring traveling vehicles and roads, and a ranging sensor which measures a distance between vehicles and the like for safe driving such as automatic stop, recognition of a driver's condition and the like.

· A device for home appliance such as a television, a refrigerator, and an air conditioner that images a user's gesture and performs device operation according to the gesture

· A device for medical and health care use such as an endoscope and a device that performs angiography by receiving infrared light

· A device for security use such as a security monitoring camera and an individual authentication camera

· A device used for beauty care, such as a skin measuring instrument for imaging skin, and a microscope for imaging the scalp

· A device used for sport, such as an action camera or a wearable camera for sports applications or the like

· A device for agriculture use, such as a camera for monitoring a condition of a field or crop.

<20. Example of application to electronic device>

The technology of the present disclosure is not limited to application to a photodetection device. That is to say, the technology of the present disclosure may be generally applied to electronic devices in which the solid-state imaging device is used in an image capturing section (photoelectric conversion section) such as an imaging device such as a digital still camera and a video camera, a portable terminal device having an imaging function, and a copying machine in which the solid-state imaging device is used in the image reading section. The photodetection device may be formed as one chip, or may be in a module form having an imaging function in which an imaging section and a signal processing section or an optical system are packaged together.

Fig. 30 is a block diagram illustrating a configuration example of an imaging device as an electronic device to which the technology of the present disclosure is applied.

An imaging device 300 in Fig. 30 includes an optical section 301 including a lens group and the like, a solid-state imaging device (imaging device) 302 in which the configuration of the photodetection device 1 in Fig. 1 is employed, and a digital signal processor (DSP) circuit 303 that is a camera signal processing circuit. Furthermore, the imaging device 300 includes a frame memory 304, a display section 305, a recording section 306, an operation section 307, and a power supply section 308. The DSP circuit 303, the frame memory 304, the display section 305, the recording section 306, the operation section 307, and the power supply section 308 are connected to one another through a bus line 309.

The optical section 301 captures incident light (image light) from a subject and forms an image on an imaging surface of the solid-state imaging device 302. The solid-state imaging device 302 converts the light amount of the incident light imaged on the imaging surface by the optical section 301 into an electrical signal in units of pixels and outputs the electrical signal as a pixel signal. As the solid-state imaging device 302, it is possible to use the solid-state imaging device including the photodetection device 1 of Fig. 1, that is, the pixel section 11 in which the pixels 21 are arranged in a matrix, in which each pixel 21 includes the photodiode 52 that photoelectrically converts incident light, the microlens 61 that focuses the incident light on the photodiode 52, and the plurality of protrusions 62 formed on the microlens 61, and the protrusions 62 are formed so that at least one of the width W, the height H, or the density $\rho$ is different in the pixel.

For example, the display section 305 includes a thin display such as a liquid crystal display (LCD) or an organic electro luminescence (EL) display, and displays a moving image or a still image captured by the solid-state imaging device 302. The recording section 306 records a moving image or a still image captured by the solid-state imaging device 302 on a recording medium such as a hard disk or a semiconductor memory.

The operation section 307 issues an operation command regarding various functions of the imaging device 300 under operation by a user. The power supply section 308 appropriately supplies various power to be operation power supply for the DSP circuit 303, the frame memory 304, the display section 305, the recording section 306, and the operation section 307, to these supply targets.

As described above, by using the photodetection device 1 described above as the solid-state imaging device 302, the light condensing effect of the microlens 61 can be improved in units of pixels, and optical characteristics can be improved. Therefore, even in the imaging device 300 such as a video camera, a digital still camera, or a camera module for a mobile device such as a mobile phone or the like, the image quality of the captured image can be improved.

<21. Example of application to mobile object>

The technology according to the present disclosure (present technology) can be applied to various products. For example, the technology of the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

Fig. 31 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 31, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 31, an audio speaker 12061, a display section 12062, and an instrument panel 12063 are illustrated as the output device. The display section 12062 may, for example, include at least one of an on-board display and a head-up display.

Fig. 32 is a diagram depicting an example of the installation position of the imaging section 12031.

In Fig. 32, the vehicle 12100 includes imaging sections 12101, 12102, 12103, 12104, and 12105 as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle, and the like. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The forward images obtained by the imaging sections 12101 and 12105 are used mainly to detect a preceding vehicle, a pedestrian, an obstacle, a traffic signal, a traffic sign, a lane, or the like.

Incidentally, Fig. 32 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology of the present disclosure can be applied to the imaging section 12031 among the configurations described above. Specifically, the photodetection device 1 can be applied as the imaging section 12031. By applying the technology according to the present disclosure to the imaging section 12031, it is possible to obtain a more easily-viewed taken image and obtain distance information while reducing the size. Furthermore, it is possible to reduce driver's fatigue and increase the safety of the driver and the vehicle by using the obtained captured image and distance information.

The technology of the present disclosure is applicable not only to the photodetection device but also to all semiconductor devices having other semiconductor integrated circuits.

The embodiment of the present disclosure is not limited to the above-described embodiments and various modifications may be made without departing from the gist of the technology of the present disclosure. For example, a form in which all or some of the plurality of configuration examples described above are combined can be employed.

The effects described in the present specification are merely examples and are not limited, and effects other than those described in the present specification may be provided.

Note that the technology of the present disclosure can have the following configurations.

(1) A photodetection device including:

pixels each including
a photoelectric conversion section that photoelectrically converts incident light,
a microlens that condenses the incident light on the photoelectric conversion section, and
a plurality of protrusions formed on the microlens, in which
the pixels each include two or more of the protrusions in which at least one of a width, a height, or a density is different.

(2) The photodetection device according to (1), in which
the two or more protrusions have different widths and heights.
(3) The photodetection device according to (1) or (2), in which
the protrusions include the same material as the microlens.
(4) The photodetection device according to any one of (1) to (3), in which
the protrusions include a material of resin, Si, SiN, $SiO_2$, SiON, or a combination thereof.
(5) The photodetection device according to any one of (1) to (4), in which
heights of the protrusions differ by 5% or more in a pixel.
(6) The photodetection device according to any one of (1) to (5), in which
a width, a height, and a density of the protrusions are formed to change from a central portion toward a peripheral portion of the microlens.
(7) The photodetection device according to any one of (1) to (6), in which
the protrusions have a shape that becomes thinner toward a distal end.
(8) The photodetection device according to any one of (1) to (7), in which
the protrusions have a conical shape, a parabolic shape, or a bell shape.
(9) The photodetection device according to any one of (1) to (8), in which
the protrusions have a shape in which a distal end is inclined toward a center side of the microlens.
(10) The photodetection device according to any one of (1) to (9), in which
the protrusions are arranged in a square array or a hexagonal close packed structure.
(11) The photodetection device according to any one of (1) to (10), in which

a pitch d of the protrusions has a following relational expression:

$$d < \lambda/(n1 + n2 \times \sin\theta)$$

with respect to a refractive index n1 of the microlens, a refractive index n2 of a medium above the microlens, a wavelength $\lambda$ of the incident light, and an angle $\theta$ of the incident light.

(12) The photodetection device according to any one of (1) to (11), in which
a height of the protrusions is 100 nm or more.
(13) The photodetection device according to any one of (1) to (12), in which
a gap through which the microlens is exposed is provided between the protrusions.
(14) The photodetection device according to (13), in which
the gap between the protrusions is 0.2 or more of a pitch of the protrusions.
(15) The photodetection device according to any one of (1) to (14), in which
a curvature radius Ra of a curved surface connecting distal ends of the protrusions and a curvature radius Rb of the microlens satisfy:

$$Ra < Rb.$$

(16) The photodetection device according to any one of (1) to (15), in which
a width of the protrusions is formed to be narrower in a peripheral portion than in a central portion of the microlens.

(17) The photodetection device according to any one of (1) to (16), in which
a density of the protrusions is formed to be smaller in a peripheral portion than in a central portion of the microlens.
(18) The photodetection device according to any one of (1) to (17), in which
a width, a height, and a density of the protrusions are different between the microlens upper surface and a pixel boundary portion.
(19) The photodetection device according to any one of (1) to (18), further including:

a pixel section in which the pixels are arranged in a matrix, in which
a width, a height, and a density of the protrusions of the pixel are different according to a distance from a center of the pixel section.

(20) The photodetection device according to any one of (1) to (19), further including:

a pixel section in which the pixels are arranged in a matrix, in which
the protrusions of the pixel is configured so that lens power increases toward an outer peripheral portion of the pixel section.

(21) The photodetection device according to any one of (1) to (20), in which
a center of an effective refractive index of the microlens including the protrusions is different from a center of the microlens not including the protrusions.
(22) The photodetection device according to any one of (1) to (21), further including:

a pixel section in which the pixels are arranged in a matrix, in which
a deviation between a center of an effective refractive index of the microlens including the protrusions and a center of the microlens not including the protrusions increases according to a distance from a center of the pixel section.

(23) The photodetection device according to any one of (1) to (22), in which
a recess formed by the protrusions is formed in a region near a center of the microlens.
(24) The photodetection device according to (23), further including:

a pixel section in which the pixels are arranged in a matrix, in which
the recess formed by the protrusions increases according to a distance from a center of the pixel section.

(25) The photodetection device according to any one of (1) to (24), in which
the protrusion is formed in a serrated shape.
(26) The photodetection device according to any one of (1) to (25), further including:

a pixel section in which the pixels are arranged in a matrix; and
a linear wall portion surrounding the pixel section.

(27) The photodetection device according to any one of (1) to (26), further including:

a pixel section in which the pixels are arranged in a matrix; and
a peripheral portion outside the pixel section, in which
the peripheral portion has a region where the protrusions are formed and a region where the protrusions are not formed.

(28) A method for manufacturing a photodetection device, the method including:
patterning a transfer film in accordance with arrangement of a plurality of protrusions formed on a microlens of a pixel, and forming the plurality of protrusions on the microlens by performing entire surface etching.
(29) An electronic device including:

a photodetection device including
pixels each including
a photoelectric conversion section that photoelectrically converts incident light,
a microlens that condenses the incident light on the photoelectric conversion section, and
a plurality of protrusions formed on the microlens, in which
the pixels each include two or more of the protrusions in which at least one of a width, a height, or a density is different.

REFERENCE SIGNS LIST

| | |
|---|---|
| 1 | Photodetection device |
| 11 | pixel section |
| 19 | Peripheral portion |
| 21 | Pixel |
| 25 | Pad |
| 51 | Semiconductor substrate |
| 52 | Photodiode |
| 56 | Color filter layer |
| 57 | Lens layer |
| 61 | Microlens |
| 62, 62' | Protrusion |
| 101 | Distal end |

| | |
|---|---|
| 102 | Bottom center |
| 151 | Flat region |
| 201 | Photodetection package |
| 211 | Adhesive |
| 221 | Wall portion |
| 300 | Imaging device |
| 302 | Solid-state imaging device |
| G | Gap |
| H | Height |
| Ra | Curvature radius |
| Ra2 | Curved Surface |
| Rb | Curvature radius |
| Rb2 | Curved Surface |
| Xa2 | Center |
| Xb2 | Center |
| d | Pitch |
| h1 | Height |
| h2 | Height |
| n1 | Refractive index |
| n2 | Refractive index |
| λ | Target wavelength |

## Claims

**1.** A photodetection device comprising:

pixels each including
a photoelectric conversion section that photoelectrically converts incident light,
a microlens that condenses the incident light on the photoelectric conversion section, and
a plurality of protrusions formed on the microlens, wherein
the pixels each include two or more of the protrusions in which at least one of a width, a height, or a density is different.

**2.** The photodetection device according to claim 1, wherein
the two or more protrusions have different widths and heights.

**3.** The photodetection device according to claim 1, wherein
the protrusions include a same material as the microlens.

**4.** The photodetection device according to claim 1, wherein
the protrusions include a material of resin, Si, SiN, $SiO_2$, SiON, or a combination thereof.

**5.** The photodetection device according to claim 1, wherein
heights of the protrusions differ by 5% or more in a pixel.

**6.** The photodetection device according to claim 1, wherein
a width, a height, and a density of the protrusions are formed to change from a central portion toward a peripheral portion of the microlens.

**7.** The photodetection device according to claim 1, wherein
the protrusions have a shape that becomes thinner toward a distal end.

**8.** The photodetection device according to claim 1, wherein
the protrusions have a conical shape, a parabolic shape, or a bell shape.

**9.** The photodetection device according to claim 1, wherein
the protrusions have a shape in which a distal end is inclined toward a center side of the microlens.

**10.** The photodetection device according to claim 1, wherein
the protrusions are arranged in a square array or a hexagonal close packed structure.

**11.** The photodetection device according to claim 1, wherein

a pitch d of the protrusions has a following relational expression:

$$d < \lambda/(n1 + n2 \times \sin\theta)$$

with respect to a refractive index n1 of the microlens, a refractive index n2 of a medium above the microlens, a wavelength λ of the incident light, and an angle θ of the incident light.

**12.** The photodetection device according to claim 1, wherein
a height of the protrusions is 100 nm or more.

**13.** The photodetection device according to claim 1, wherein
a gap through which the microlens is exposed is provided between the protrusions.

**14.** The photodetection device according to claim 13, wherein
the gap between the protrusions is 0.2 or more of a pitch of the protrusions.

**15.** The photodetection device according to claim 1, wherein
a curvature radius Ra of a curved surface connecting distal ends of the protrusions and a curvature radius Rb of the microlens satisfy:

Ra < Rb.

**16.** The photodetection device according to claim 1, wherein
a width of the protrusions is formed to be narrower in a peripheral portion than in a central portion of the microlens.

**17.** The photodetection device according to claim 1, wherein
a density of the protrusions is formed to be smaller in a peripheral portion than in a central portion of the microlens.

**18.** The photodetection device according to claim 1, wherein
a width, a height, and a density of the protrusions are different between the microlens upper surface and a pixel boundary portion.

**19.** The photodetection device according to claim 1, further comprising:

a pixel section in which the pixels are arranged in a matrix, wherein
a width, a height, and a density of the protrusions of the pixel are different according to a distance from a center of the pixel section.

**20.** The photodetection device according to claim 1, further comprising:

a pixel section in which the pixels are arranged in a matrix, wherein
the protrusions of the pixel is configured so that lens power increases toward an outer peripheral portion of the pixel section.

**21.** The photodetection device according to claim 1, wherein
a center of an effective refractive index of the microlens including the protrusions is different from a center of the microlens not including the protrusions.

**22.** The photodetection device according to claim 1, further comprising:

a pixel section in which the pixels are arranged in a matrix, wherein
a deviation between a center of an effective refractive index of the microlens including the protrusions and a center of the microlens not including the protrusions increases according to a distance from a center of the pixel section.

**23.** The photodetection device according to claim 1, wherein
a recess formed by the protrusions is formed in a region near a center of the microlens.

**24.** The photodetection device according to claim 23, further including:

a pixel section in which the pixels are arranged in a matrix, wherein
the recess formed by the protrusions increases according to a distance from a center of the pixel section.

**25.** The photodetection device according to claim 1, wherein
the protrusion is formed in a serrated shape.

**26.** The photodetection device according to claim 1, further comprising:

a pixel section in which the pixels are arranged in a matrix; and
a linear wall portion surrounding the pixel section.

**27.** The photodetection device according to claim 1, further comprising:

a pixel section in which the pixels are arranged in a matrix; and
a peripheral portion outside the pixel section, wherein
the peripheral portion has a region where the protrusions are formed and a region where the protrusions are not formed.

**28.** A method for manufacturing a photodetection device, the method comprising:
patterning a transfer film in accordance with arrangement of a plurality of protrusions formed on a microlens of a pixel, and forming the plurality of protrusions on the microlens by performing entire surface etching.

**29.** An electronic device comprising:

a photodetection device including
pixels each including
a photoelectric conversion section that photoelectrically converts incident light,
a microlens that condenses the incident light on the photoelectric conversion section, and
a plurality of protrusions formed on the microlens, wherein
the pixels each include two or more of the protrusions in which at least one of a width, a height, or a density is different.

FIG. 1

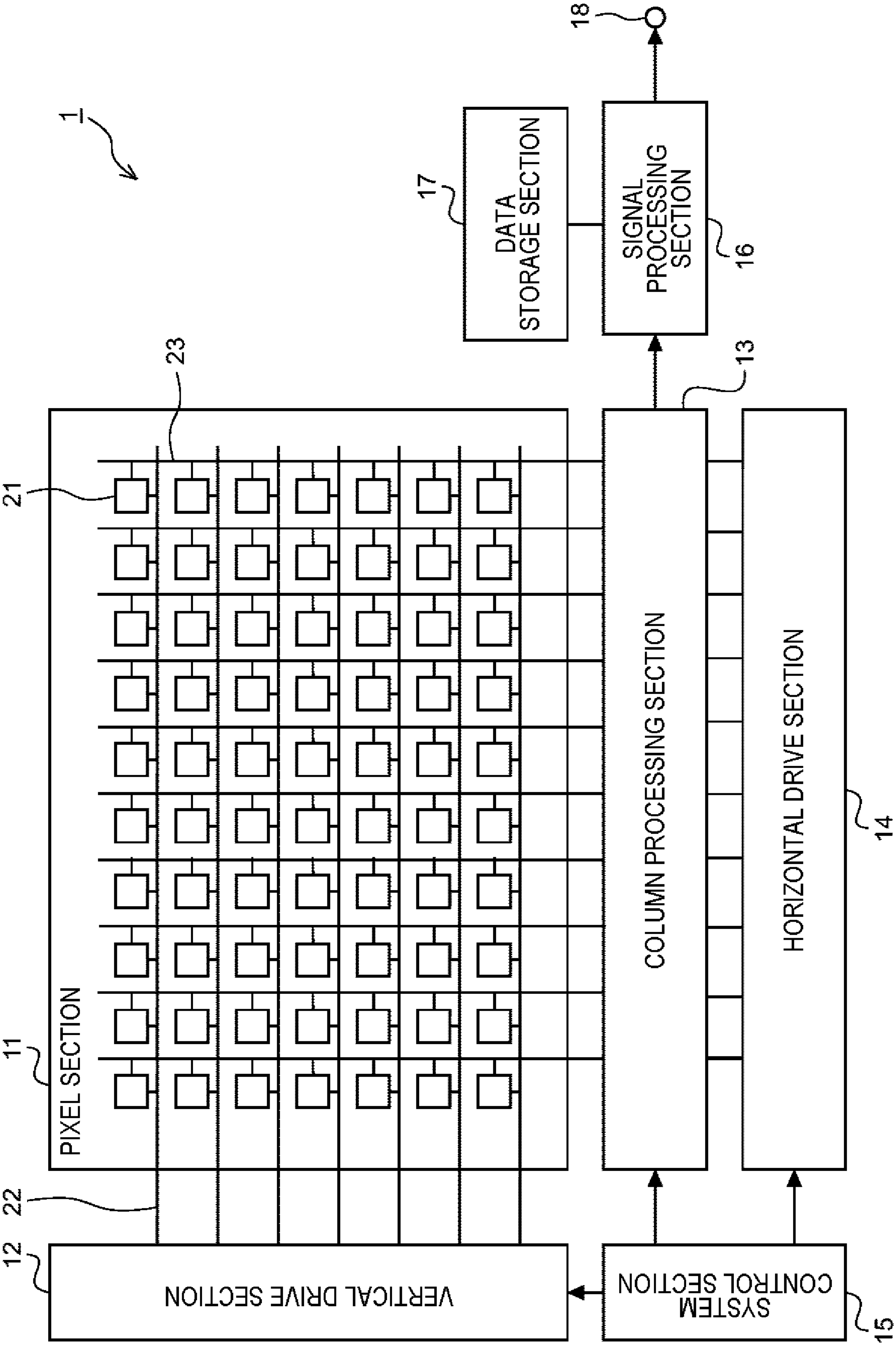
1
PIXEL SECTION
11
12
13
14
15
16
17
18
21
22
23
VERTICAL DRIVE SECTION
SYSTEM CONTROL SECTION
COLUMN PROCESSING SECTION
HORIZONTAL DRIVE SECTION
SIGNAL PROCESSING SECTION
DATA STORAGE SECTION

FIG. 2

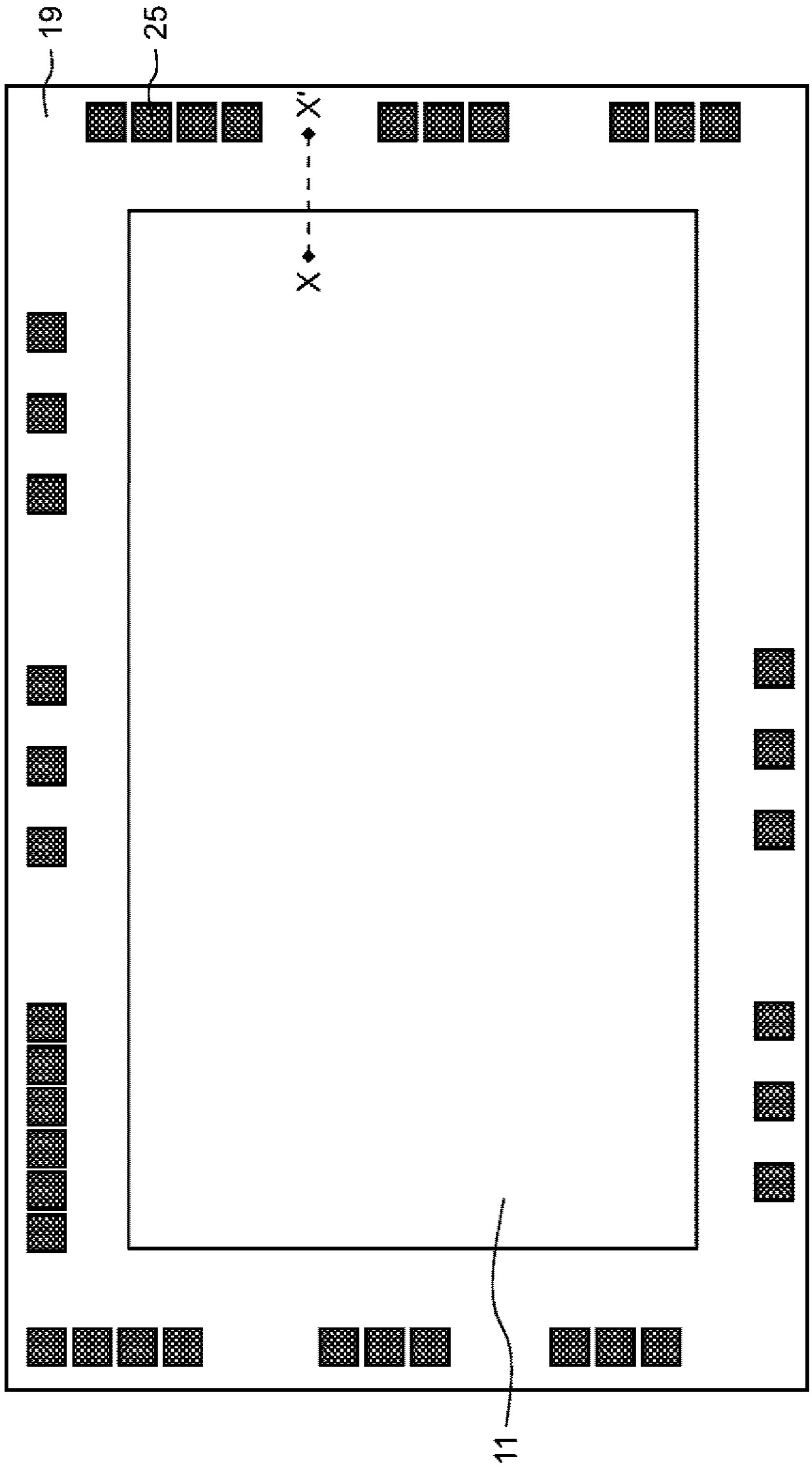

FIG. 3

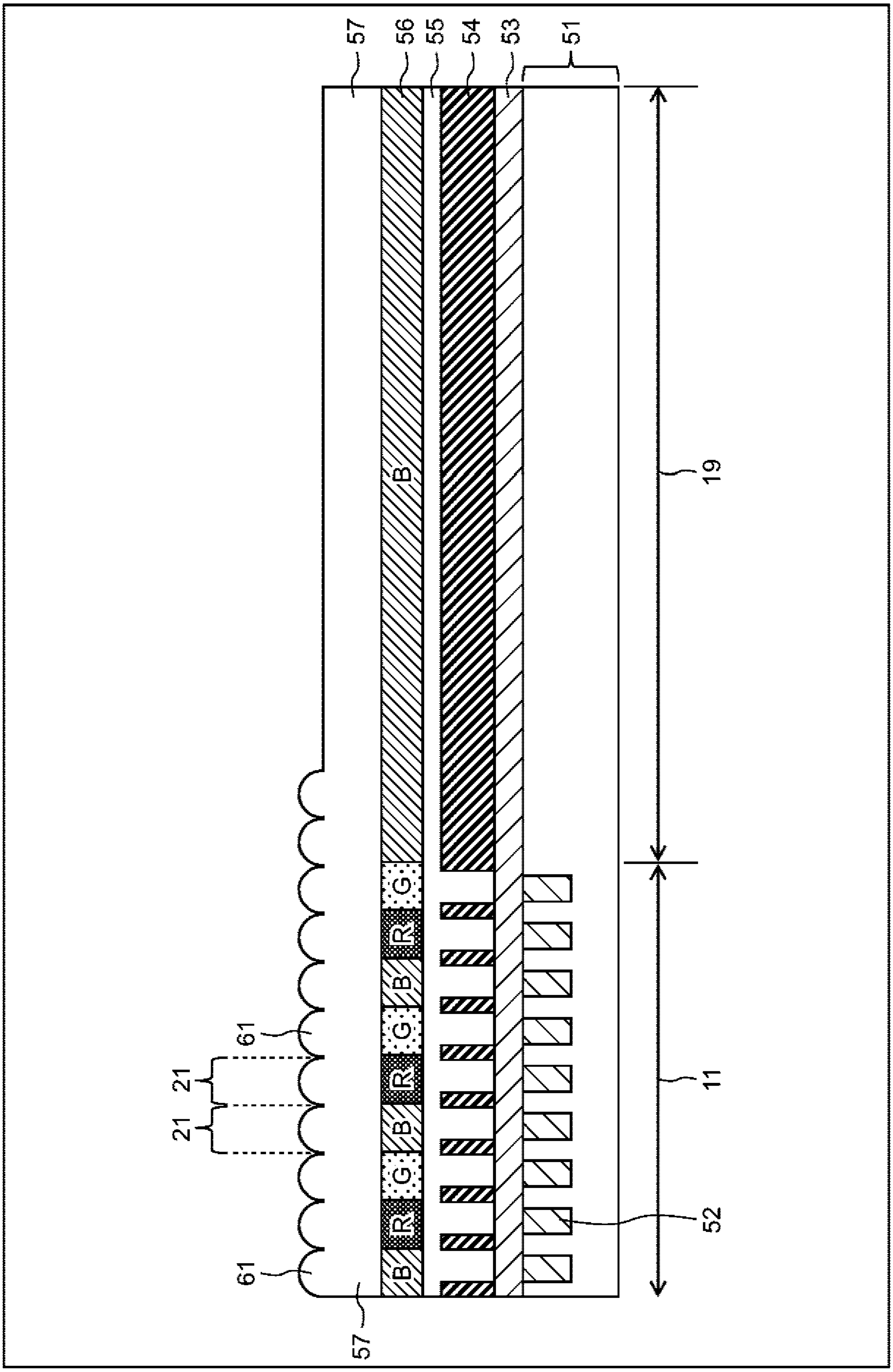

FIG. 4

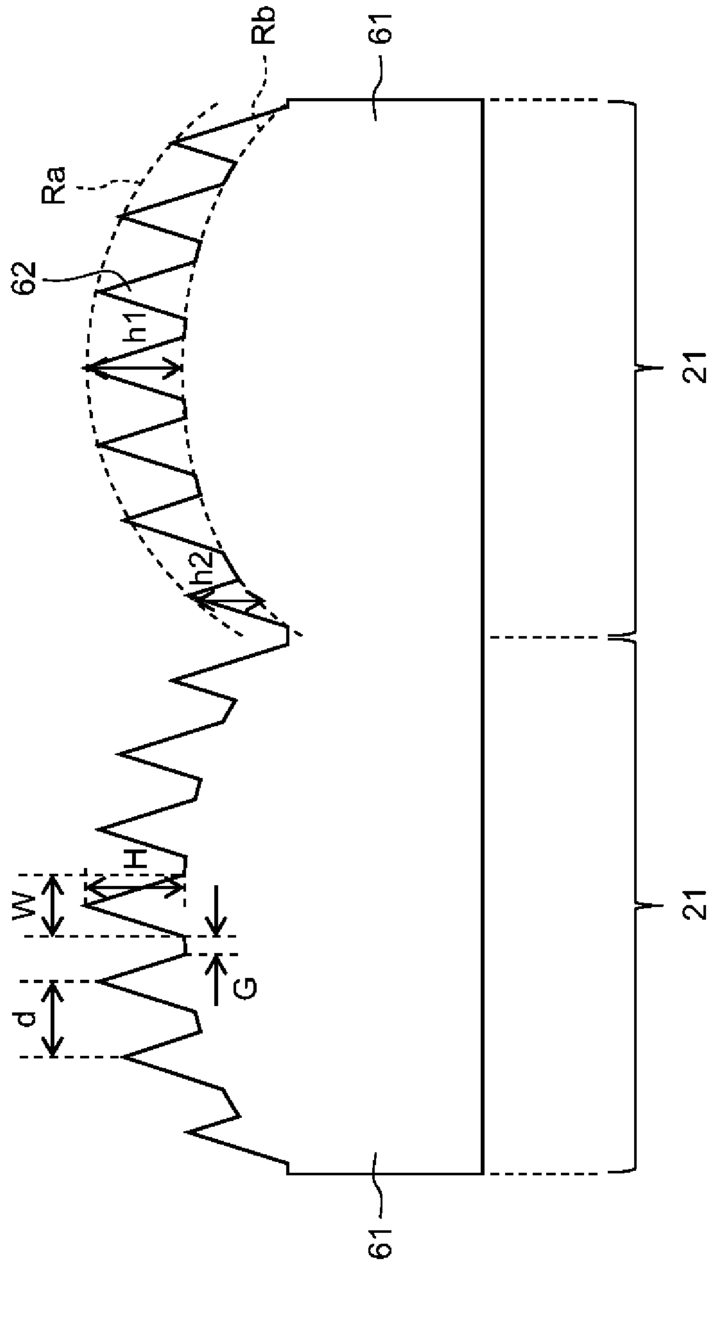

FIG. 5

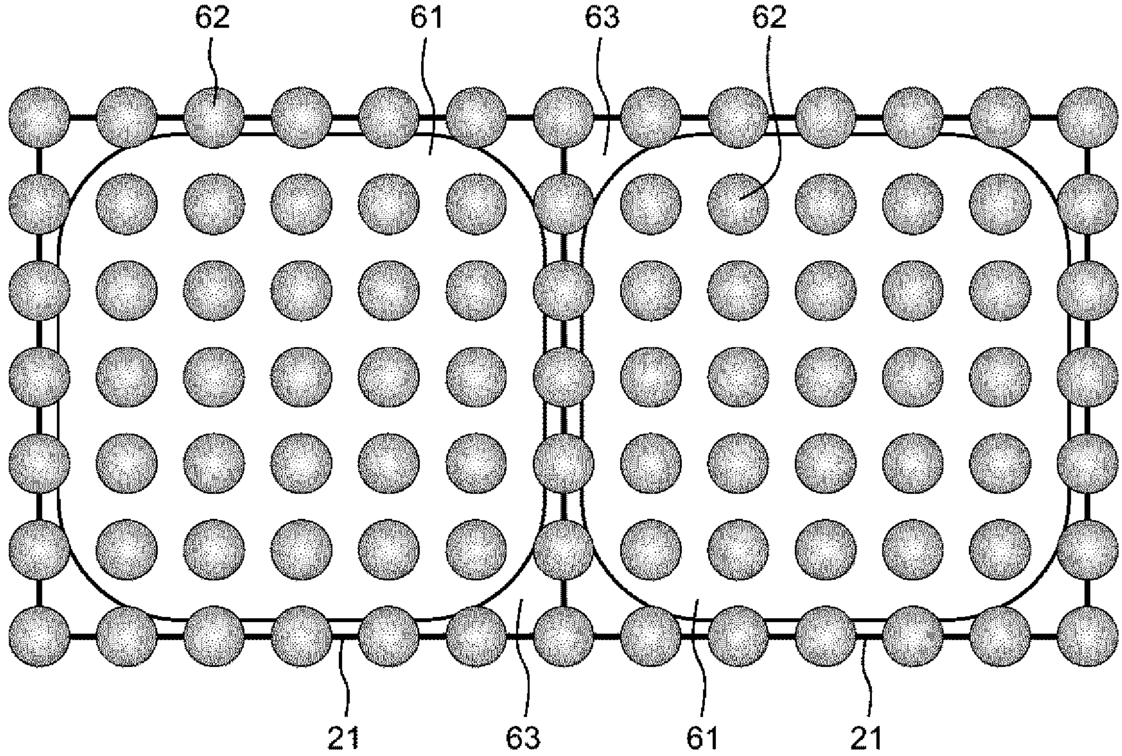


FIG. 6

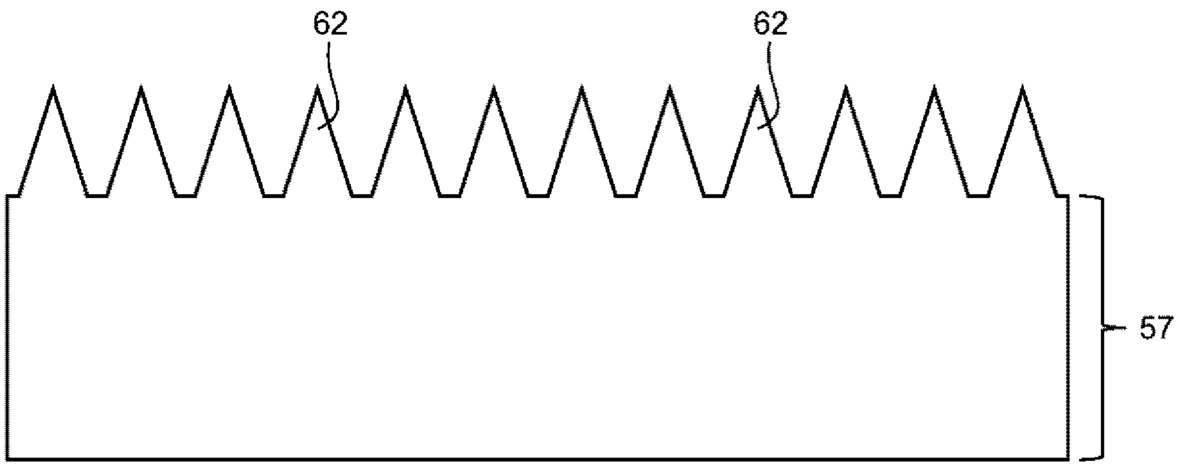

FIG. 7

MEDIUM: AIR (n2=1.0)

| | | | MATERIAL | | | | | |
|---|---|---|---|---|---|---|---|---|
| | | | SiN | | ACRYLIC STYRENE RESIN | | AMORPHOUS Si | |
| | WAVELENGTH λ | INCIDENT ANGLE θ | PITCH d | REFRACTIVE INDEX n1 | PITCH d | REFRACTIVE INDEX n1 | PITCH d | REFRACTIVE INDEX n1 |
| AVERAGE VALUE OF VISIBLE LIGHT | 550 nm | 0 deg | 282 nm | 1.95 | 348 nm | 1.58 | — | — |
| LOWER LIMIT VALUE OF VISIBLE LIGHT | 400 nm | 0 deg | 209 nm | 1.91 | 250 nm | 1.6 | — | — |
| | 400 nm | -90 deg | 137 nm | 1.91 | 154 nm | 1.6 | — | — |
| IR TARGET WAVELENGTH ① | 850 nm | 0 deg | 450 nm | 1.89 | 545 nm | 1.56 | 232 nm | 3.67 |
| | 850 nm | -90 deg | 294 nm | 1.89 | 332 nm | 1.56 | 182 nm | 3.67 |
| IR TARGET WAVELENGTH ② | 940 nm | 0 deg | 497 nm | 1.89 | 606 nm | 1.55 | 261 nm | 3.6 |
| | 940 nm | -90 deg | 325 nm | 1.89 | 369 nm | 1.55 | 204 nm | 3.6 |

FIG. 8

MEDIUM: FLUOROSILOXANE RESIN (n2=1.41)

| | | | MATERIAL | | | | | |
|---|---|---|---|---|---|---|---|---|
| | | | SiN | | ACRYLIC STYRENE RESIN | | AMORPHOUS Si | |
| | WAVELENGTH λ | INCIDENT ANGLE θ | PITCH d | REFRACTIVE INDEX n1 | PITCH d | REFRACTIVE INDEX n1 | PITCH d | REFRACTIVE INDEX n1 |
| AVERAGE VALUE OF VISIBLE LIGHT | 550 nm | 0 deg | 282 nm | 1.95 | 348 nm | 1.58 | — | — |
| LOWER LIMIT VALUE OF VISIBLE LIGHT | 400 nm | 0 deg | 209 nm | 1.91 | 250 nm | 1.6 | — | — |
| | 400 nm | -90 deg | 120 nm | 1.91 | 133 nm | 1.6 | — | — |
| IR TARGET WAVELENGTH ① | 850 nm | 0 deg | 450 nm | 1.89 | 545 nm | 1.56 | 232 nm | 3.67 |
| | 850 nm | -90 deg | 258 nm | 1.89 | 286nm | 1.56 | 167 nm | 3.67 |
| IR TARGET WAVELENGTH ② | 940 nm | 0 deg | 497 nm | 1.89 | 606 nm | 1.55 | 261 nm | 3.6 |
| | 940 nm | -90 deg | 285nm | 1.89 | 318 nm | 1.55 | 188nm | 3.6 |

FIG. 9

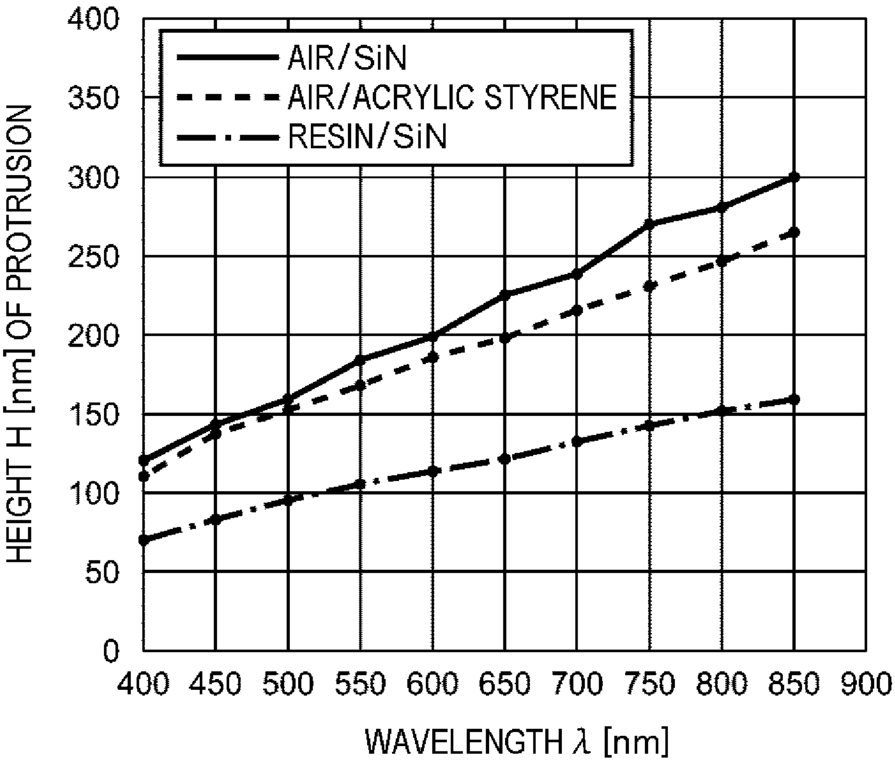
AIR/SiN
AIR/ACRYLIC STYRENE
RESIN/SiN
HEIGHT H [nm] OF PROTRUSION
400
350
300
250
200
150
100
50
0
400 450 500 550 600 650 700 750 800 850 900
WAVELENGTH λ [nm]

FIG. 10

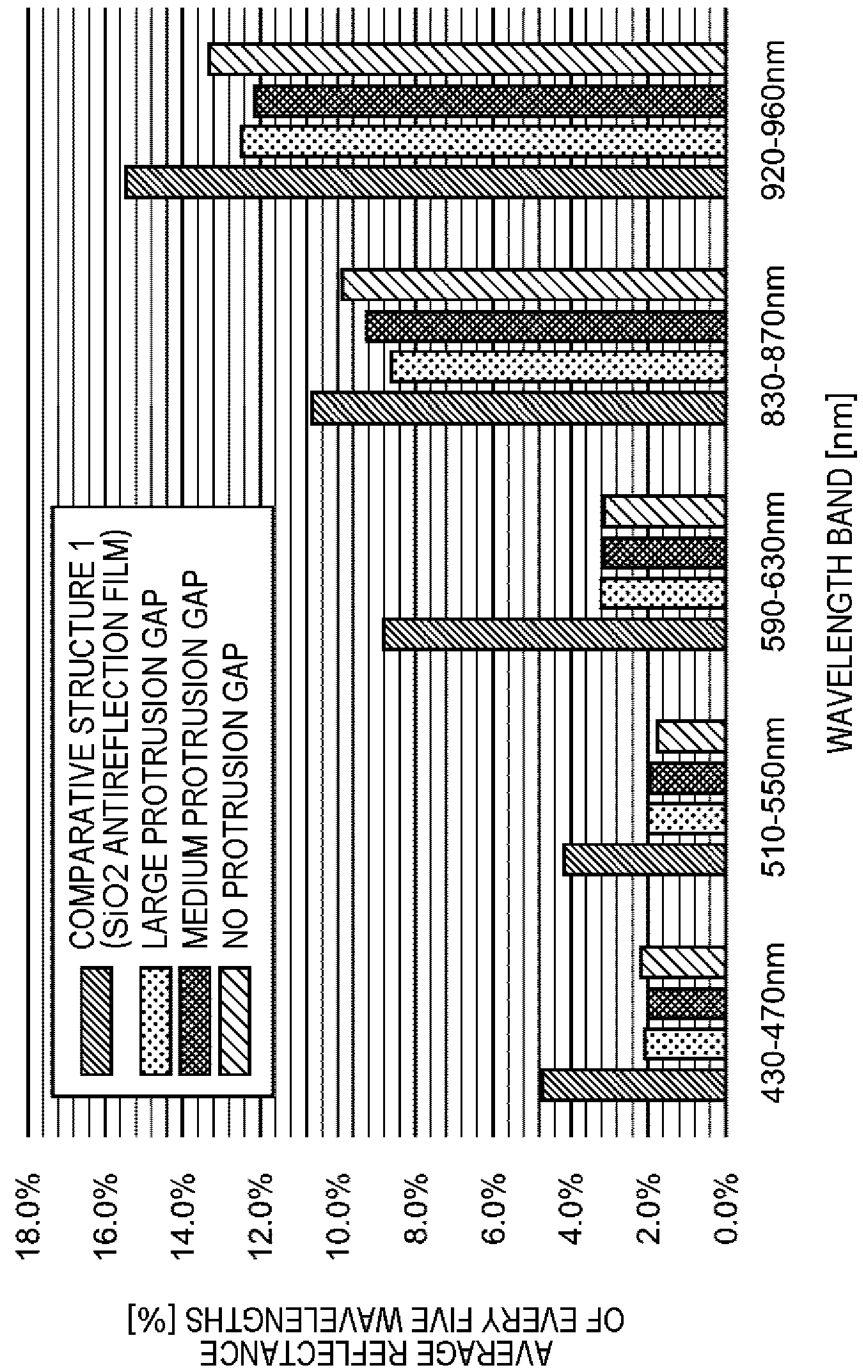
COMPARATIVE STRUCTURE 1
(SiO2 ANTIREFLECTION FILM)
LARGE PROTRUSION GAP
MEDIUM PROTRUSION GAP
NO PROTRUSION GAP
AVERAGE REFLECTANCE
OF EVERY FIVE WAVELENGTHS [%]
18.0%
16.0%
14.0%
12.0%
10.0%
8.0%
6.0%
4.0%
2.0%
0.0%
430-470nm
510-550nm
590-630nm
830-870nm
920-960nm
WAVELENGTH BAND [nm]

FIG. 11

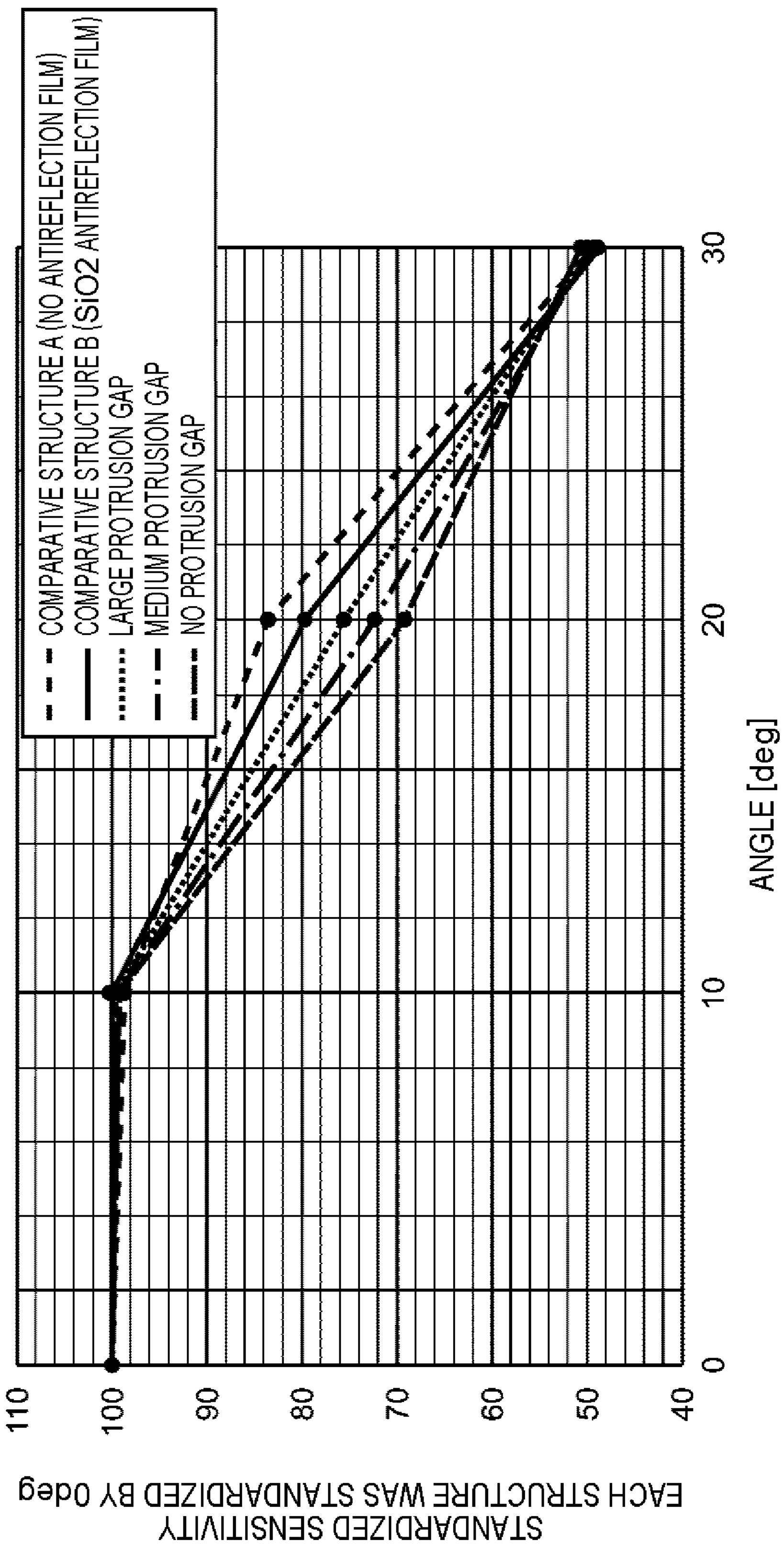
COMPARATIVE STRUCTURE A (NO ANTIREFLECTION FILM)
COMPARATIVE STRUCTURE B (SiO2 ANTIREFLECTION FILM)
LARGE PROTRUSION GAP
MEDIUM PROTRUSION GAP
NO PROTRUSION GAP
110
100
90
80
70
60
50
40
0
10
20
30
ANGLE [deg]
STANDARDIZED SENSITIVITY
EACH STRUCTURE WAS STANDARDIZED BY 0deg

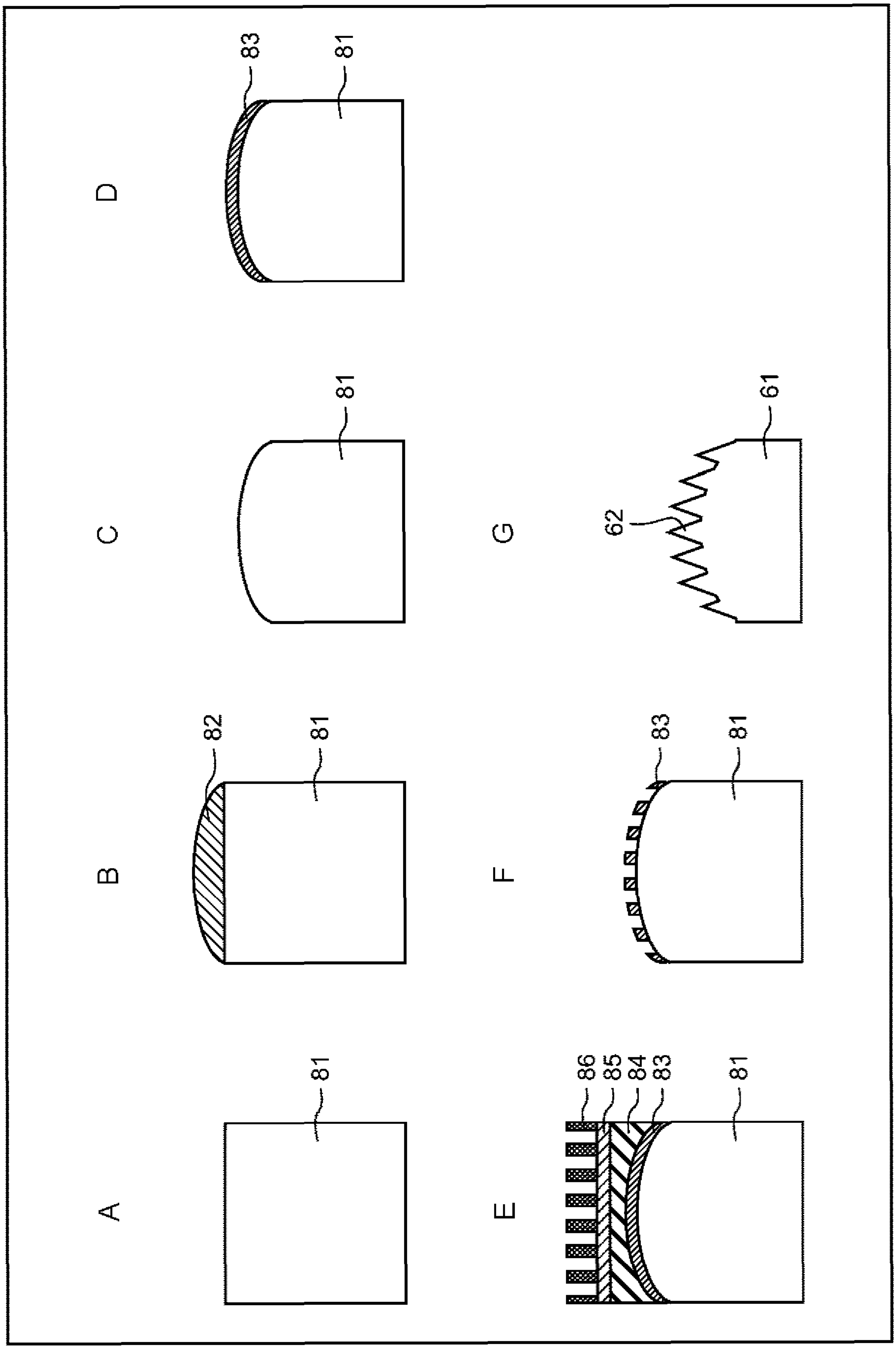


FIG. 12

FIG. 13

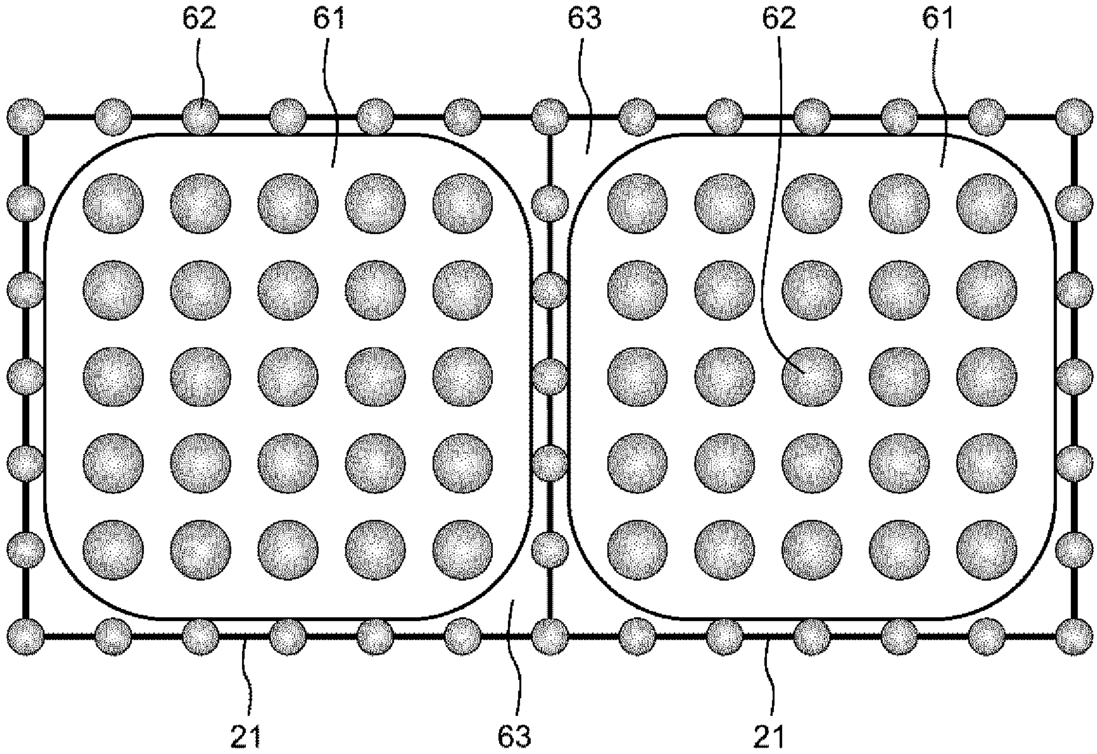


FIG. 14

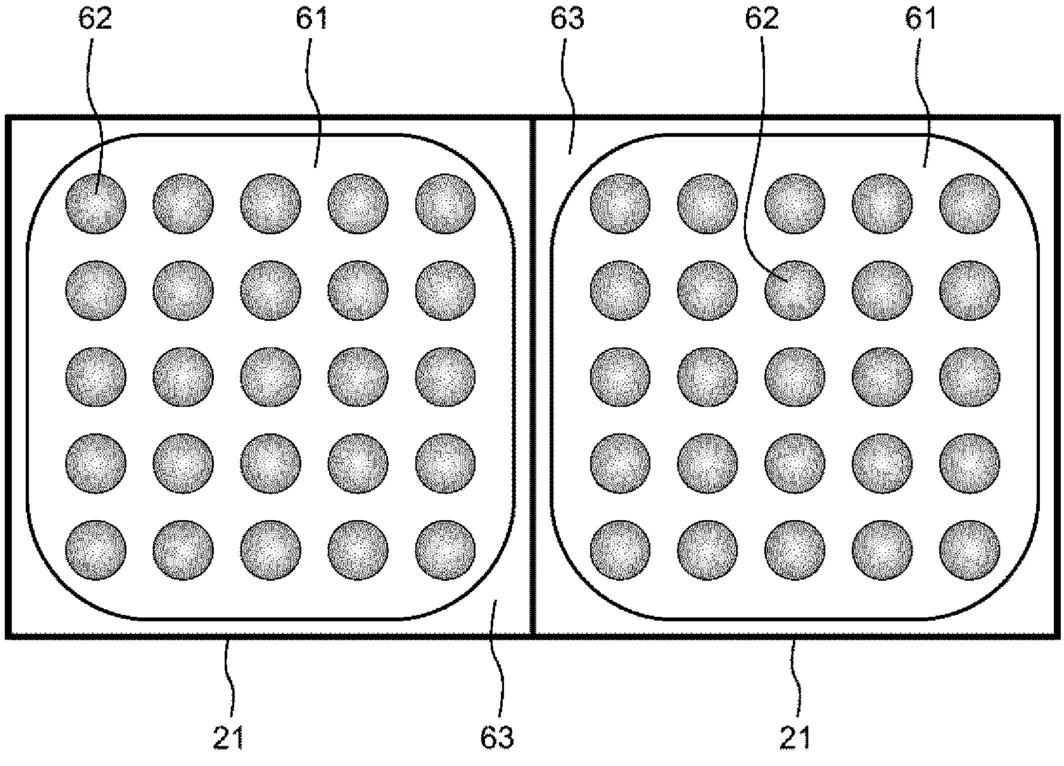

FIG. 15

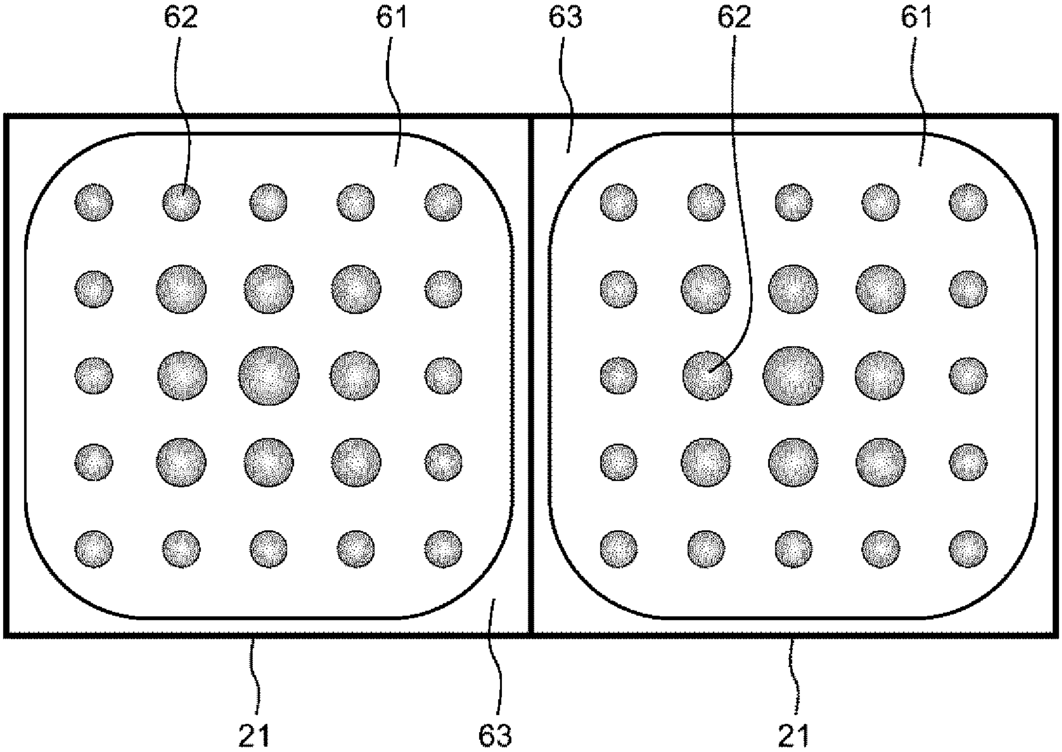


FIG. 16

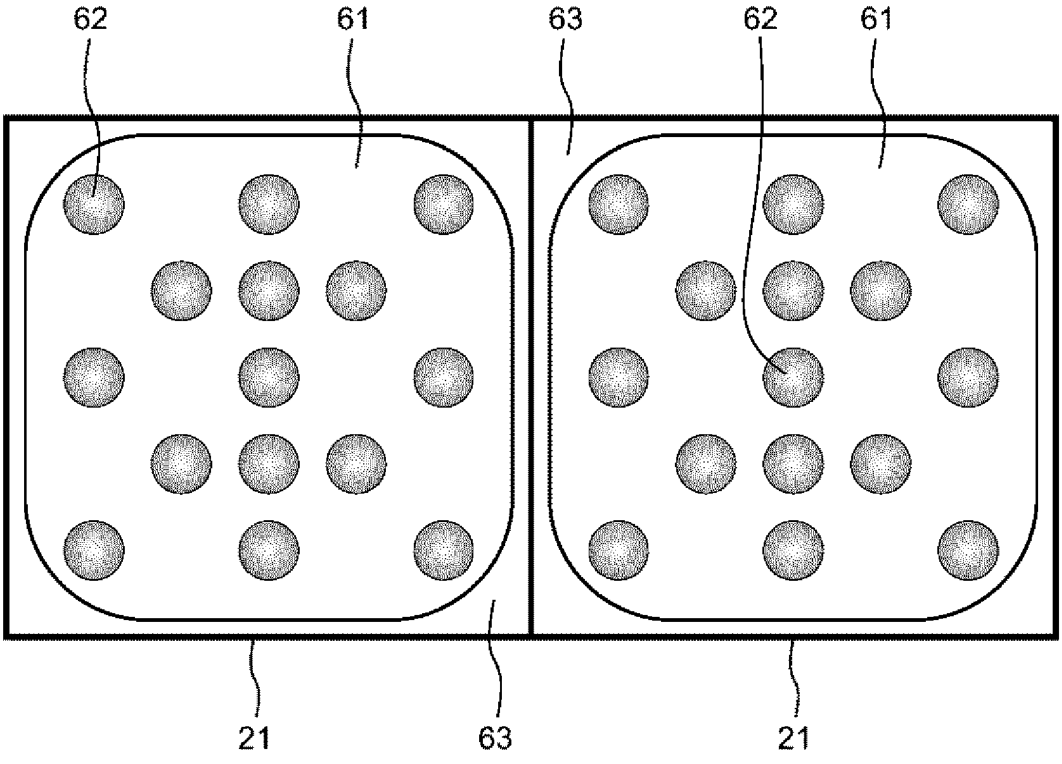

FIG. 17

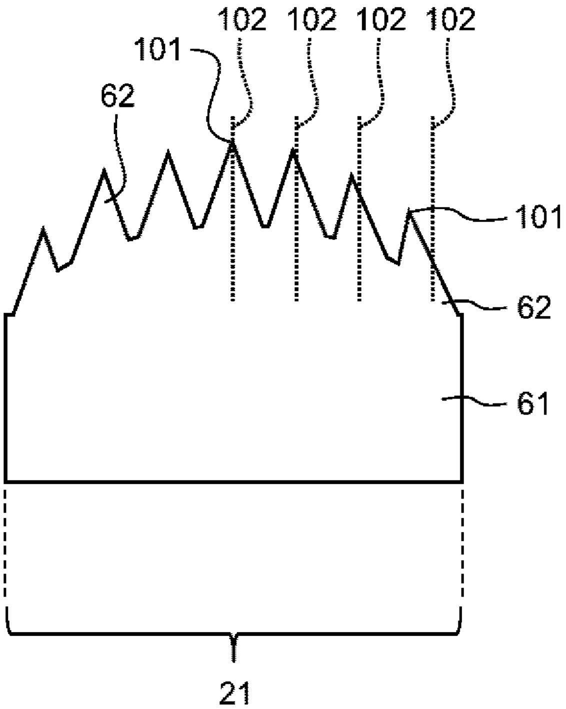

FIG. 18

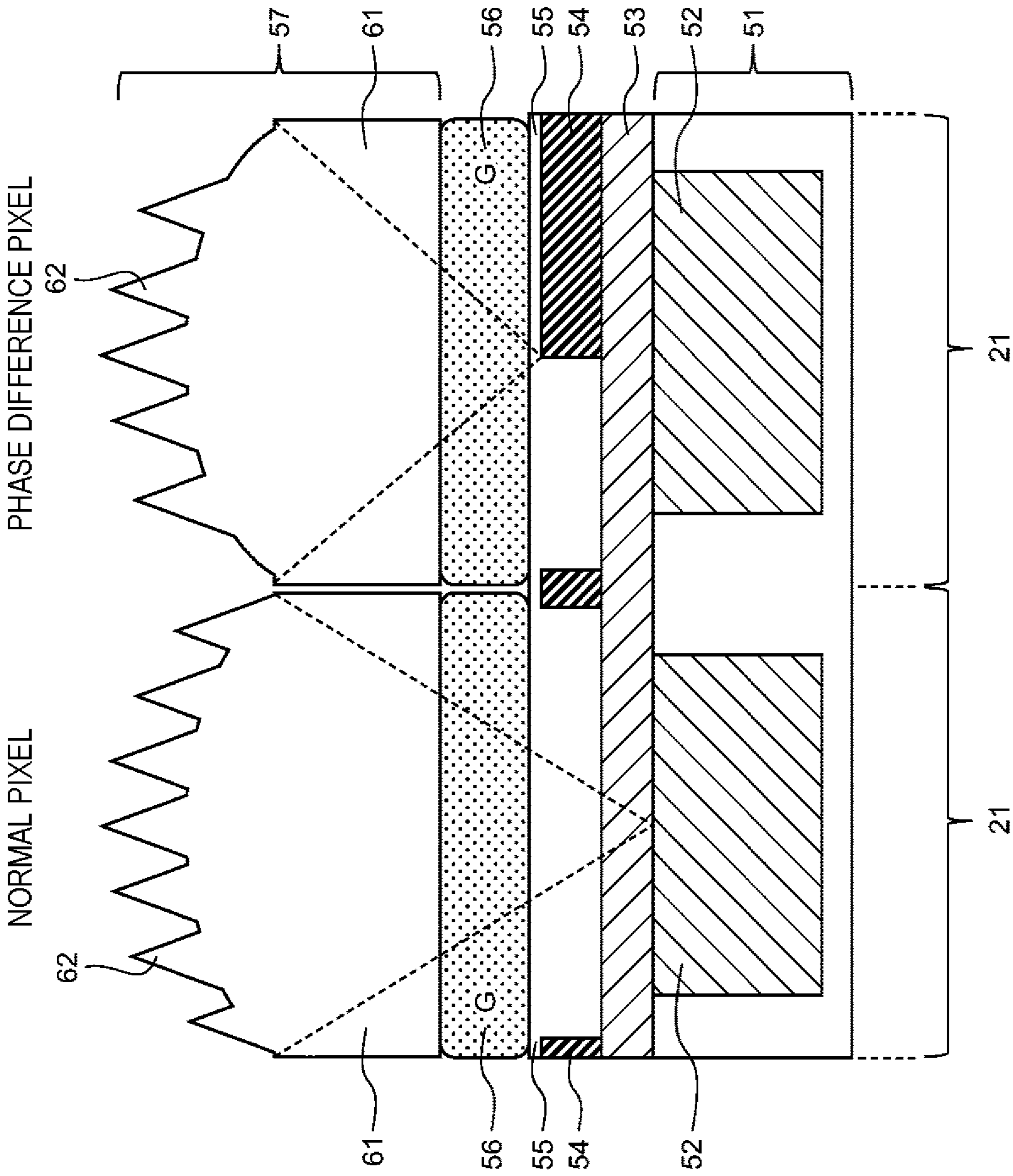
NORMAL PIXEL
PHASE DIFFERENCE PIXEL
57
61
56
55
54
53
52
51
62
G
21

FIG. 19

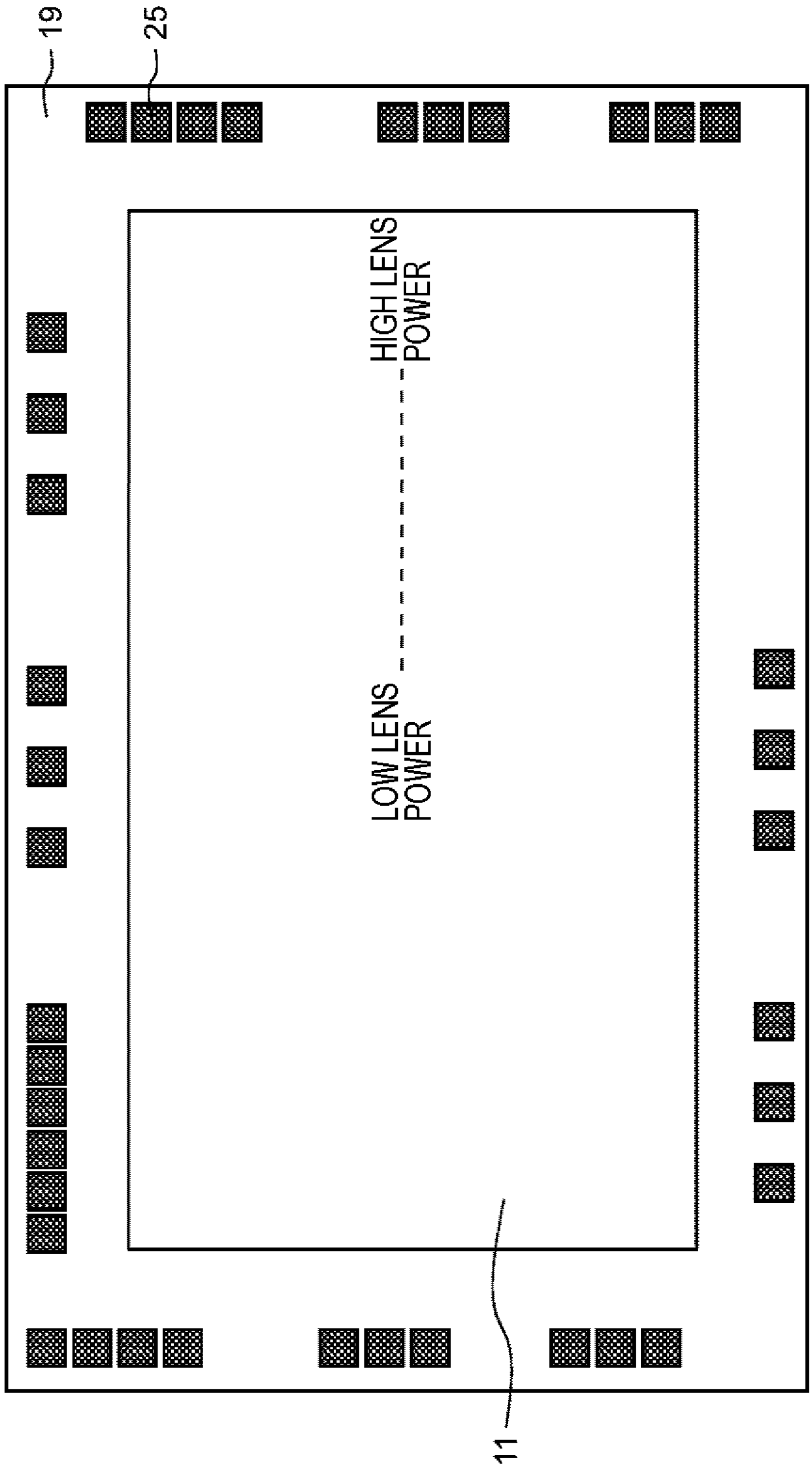

FIG. 20

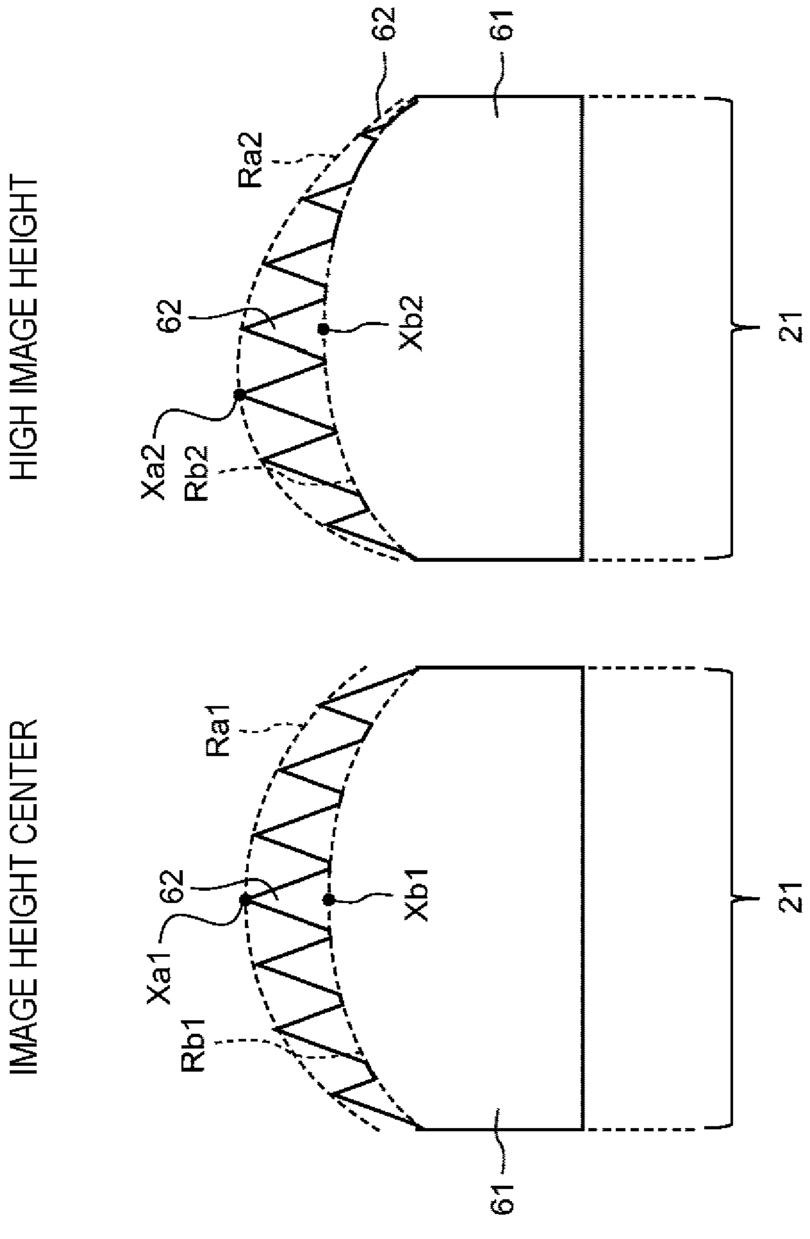
IMAGE HEIGHT CENTER
HIGH IMAGE HEIGHT
Ra1
Rb1
Xa1
Xb1
62
61
21
Ra2
Rb2
Xa2
Xb2
62
61
21

FIG. 21

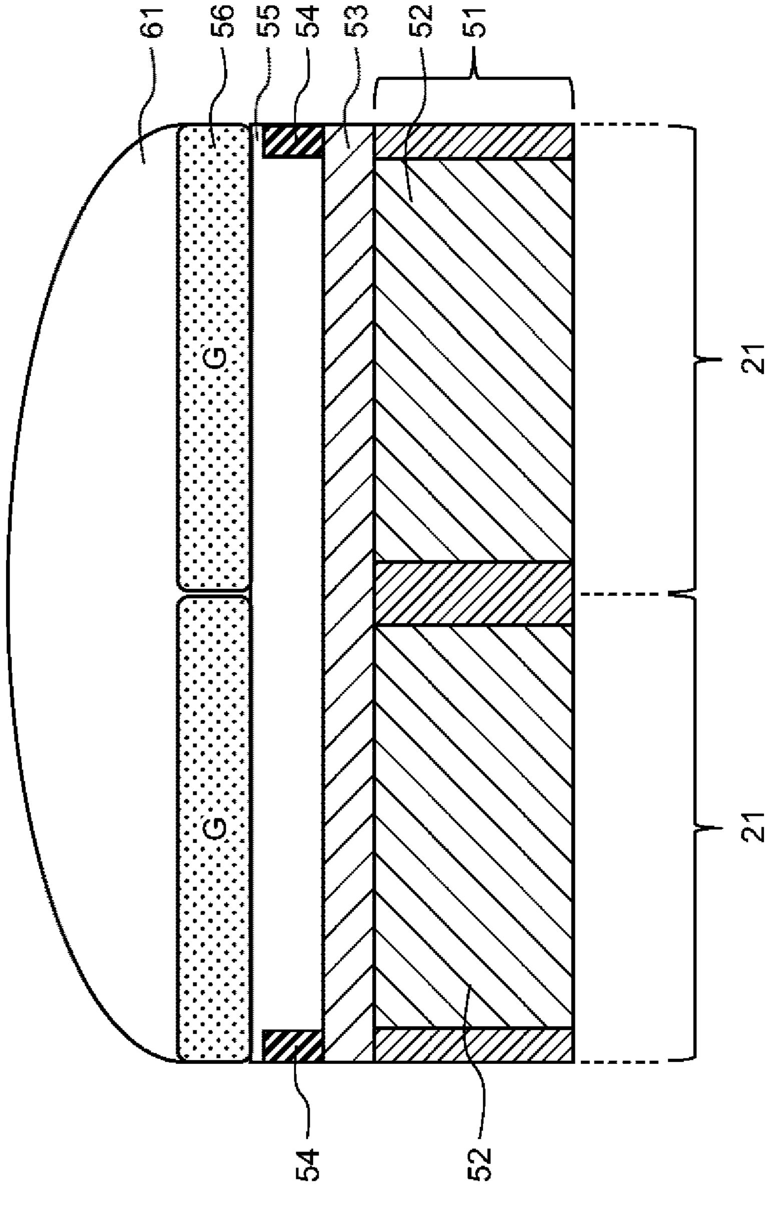

FIG. 22

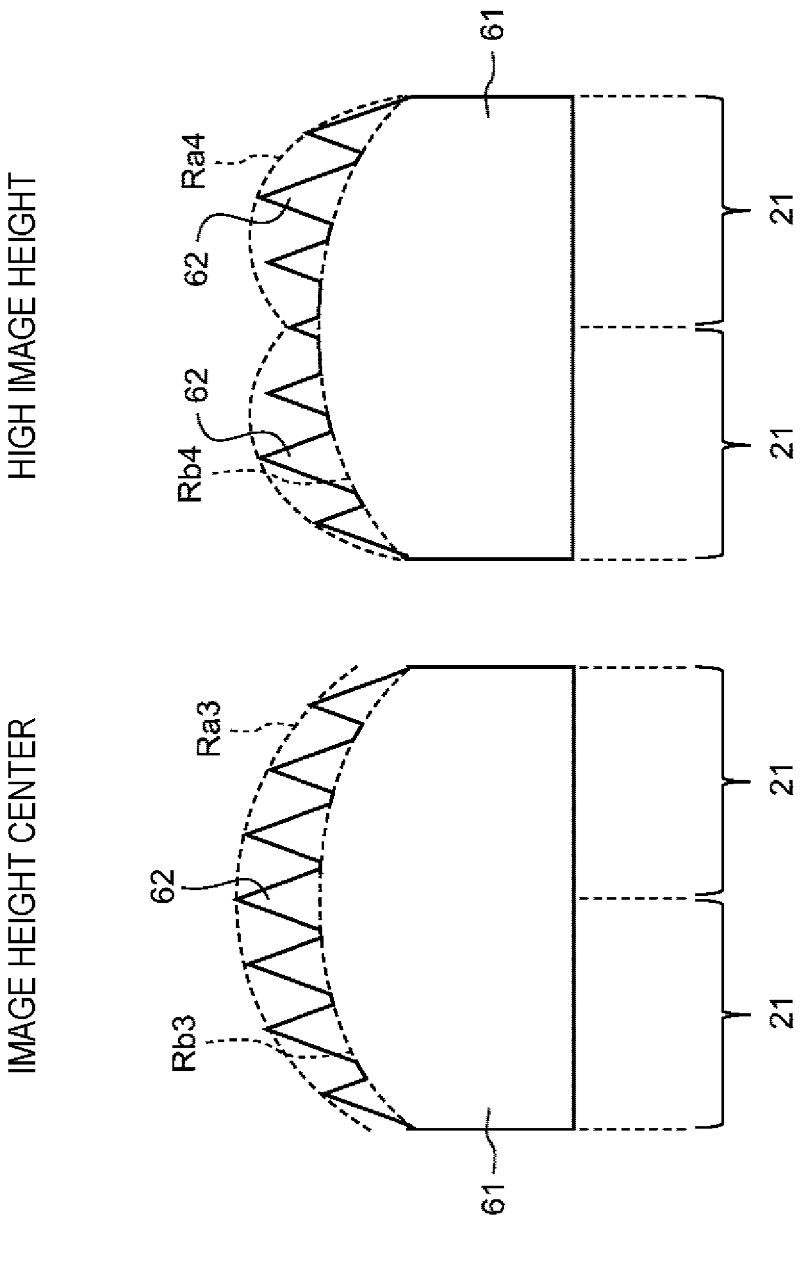
IMAGE HEIGHT CENTER
HIGH IMAGE HEIGHT
61
62
Ra3
Rb3
Ra4
Rb4
21

FIG. 23

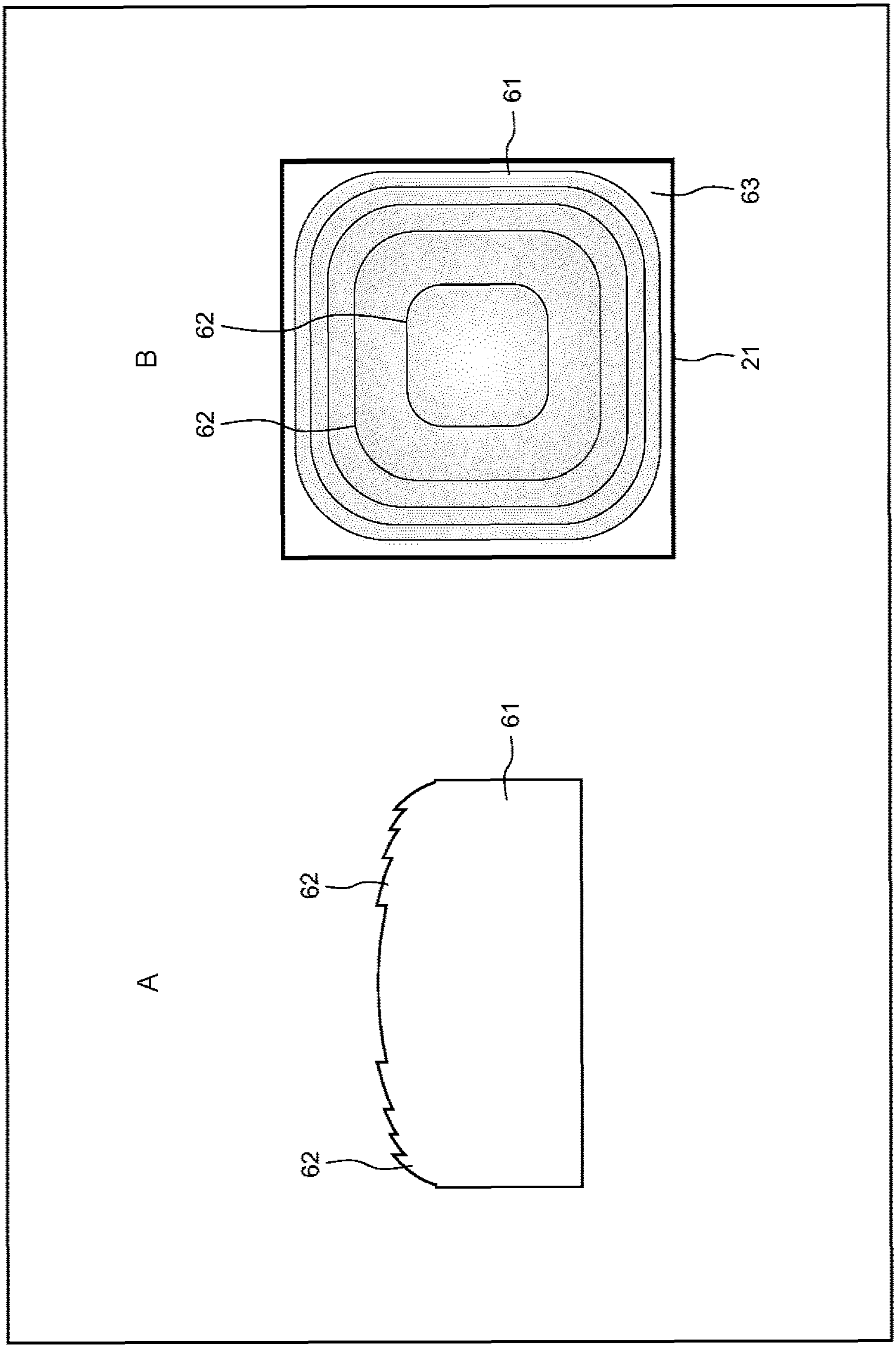

FIG. 24

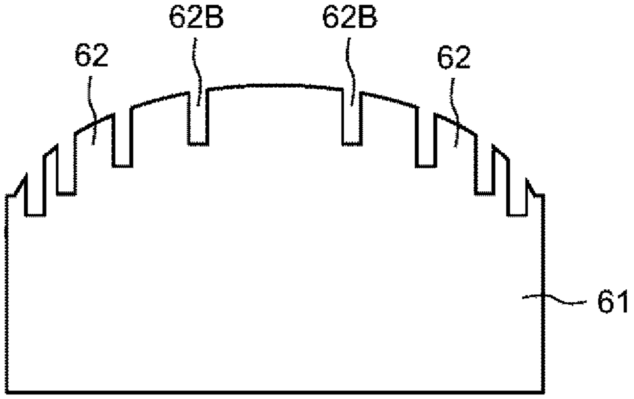


FIG. 25

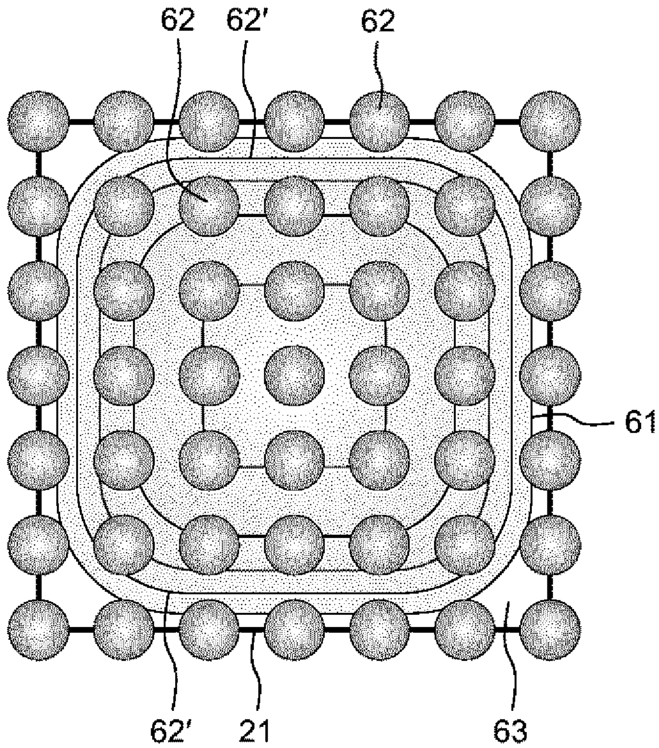

FIG. 26

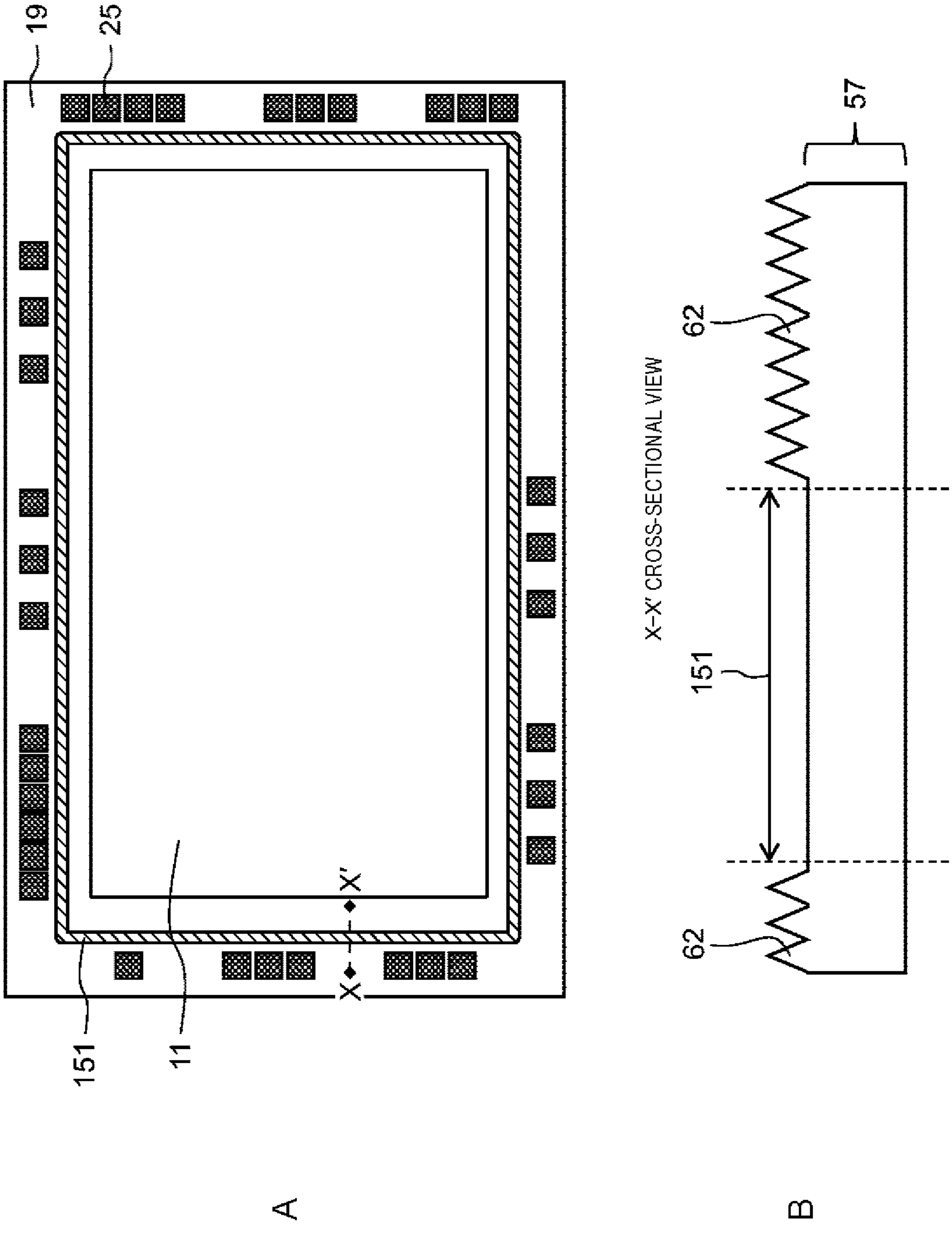

FIG. 27

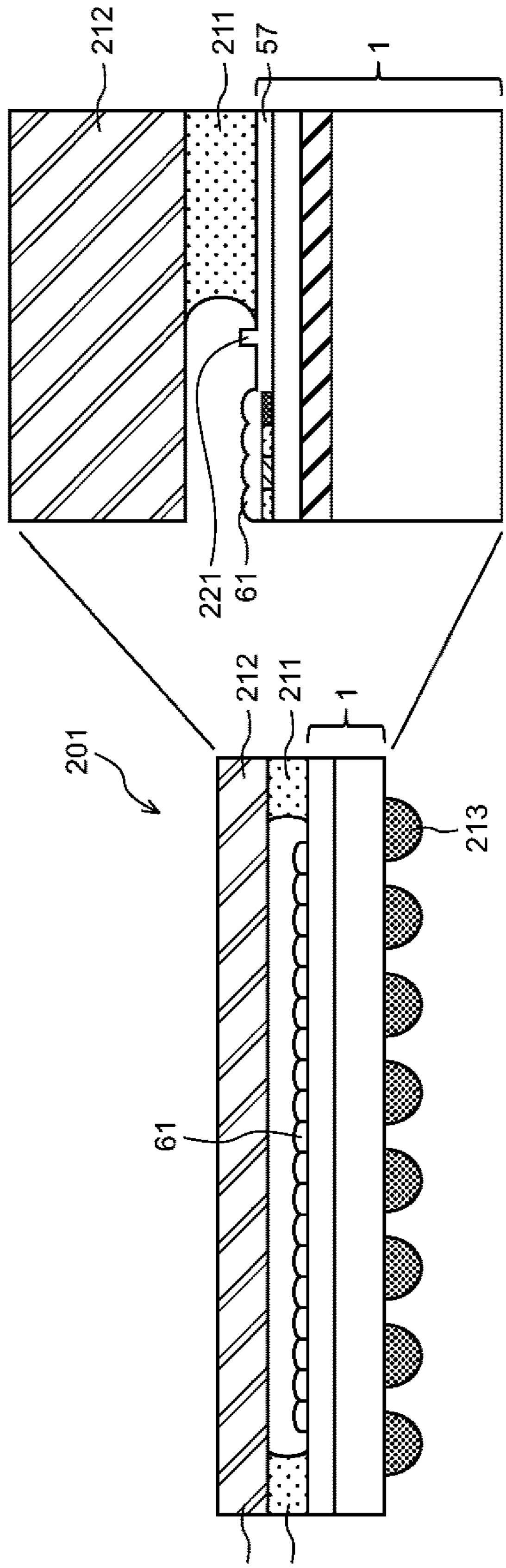

FIG. 28

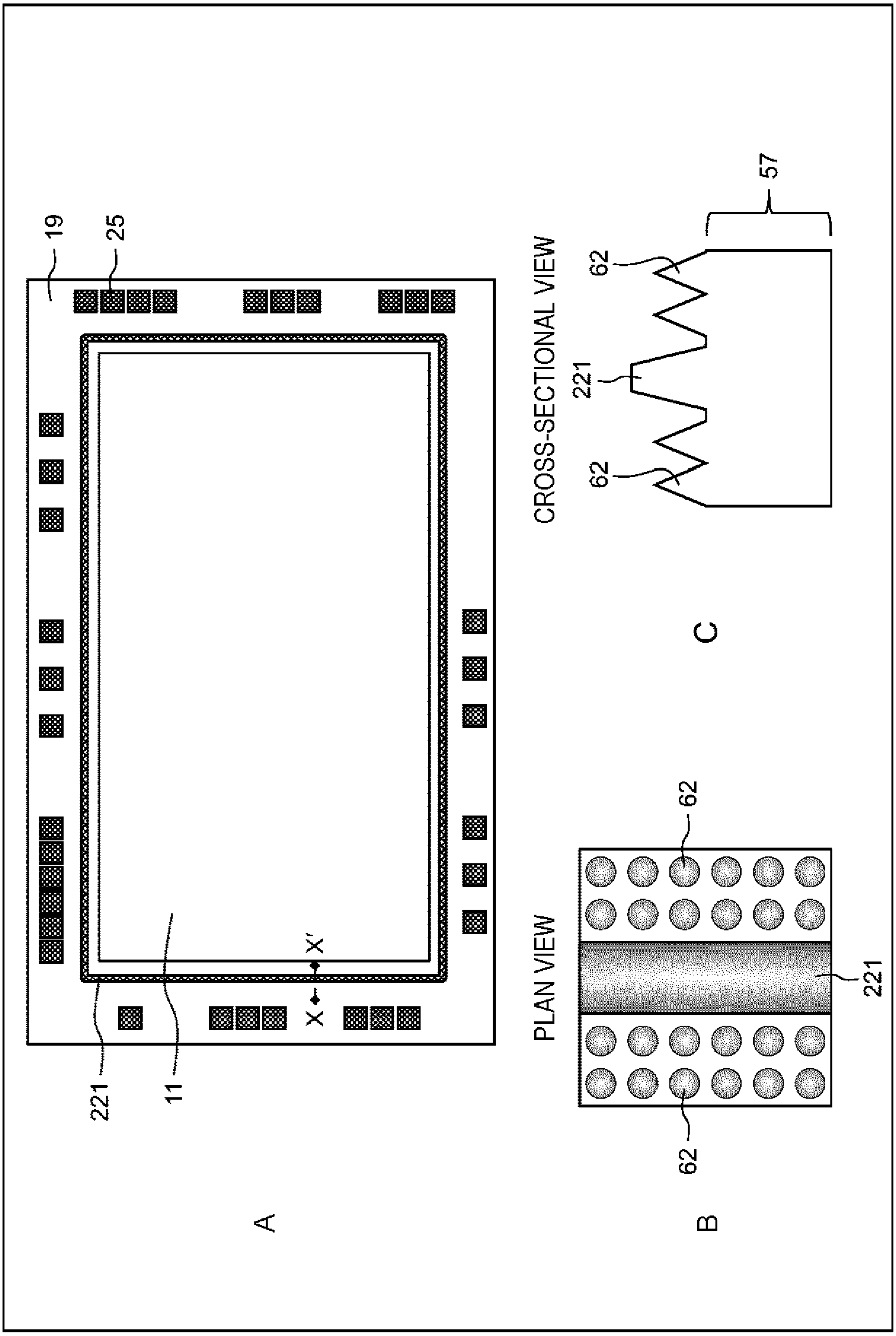
19
25
221
11
X
X'
A
PLAN VIEW
62
62
221
B
C
CROSS-SECTIONAL VIEW
62
221
62
57

FIG. 29

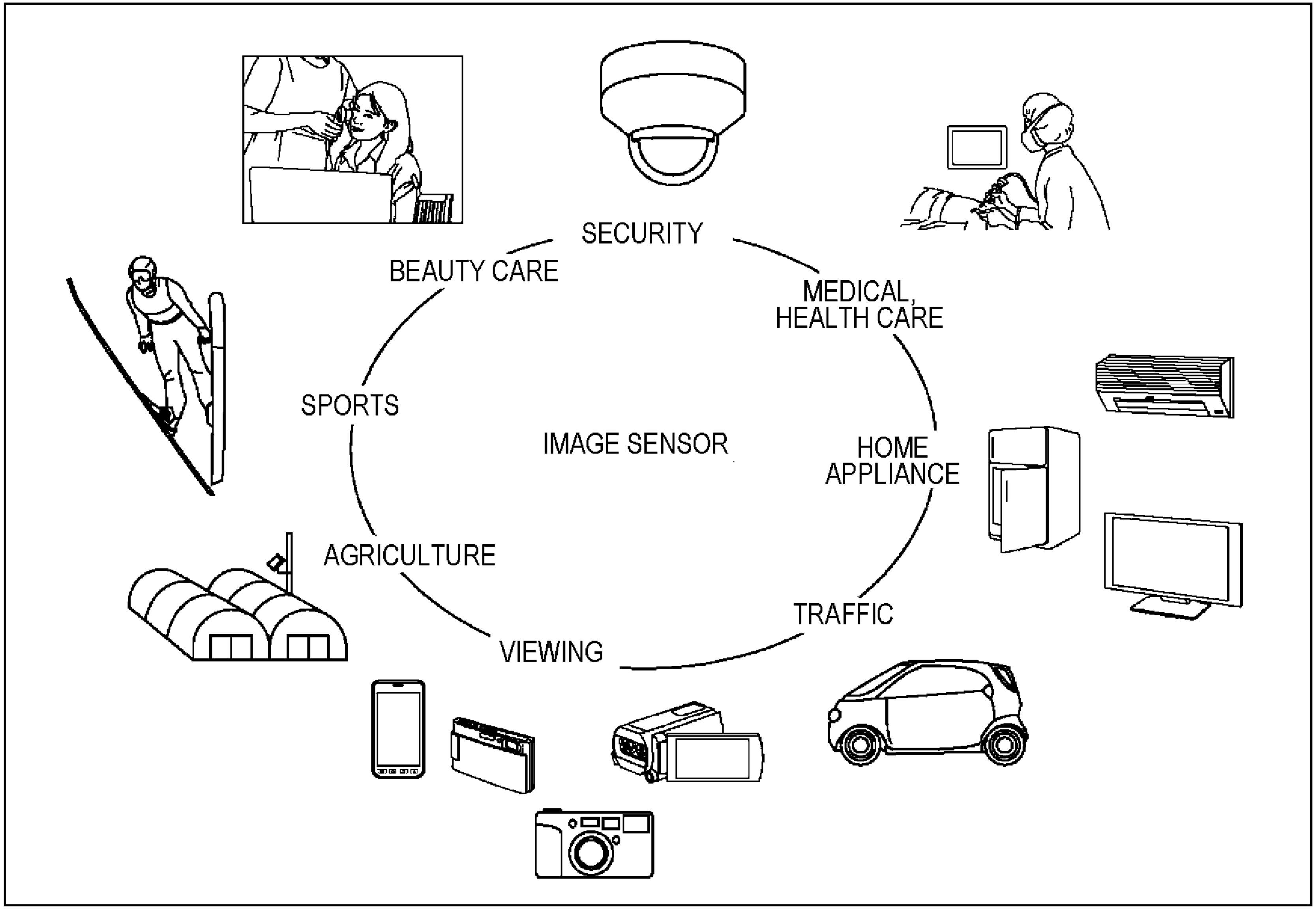
SECURITY
BEAUTY CARE
MEDICAL,
HEALTH CARE
SPORTS
IMAGE SENSOR
HOME
APPLIANCE
AGRICULTURE
TRAFFIC
VIEWING

FIG. 30

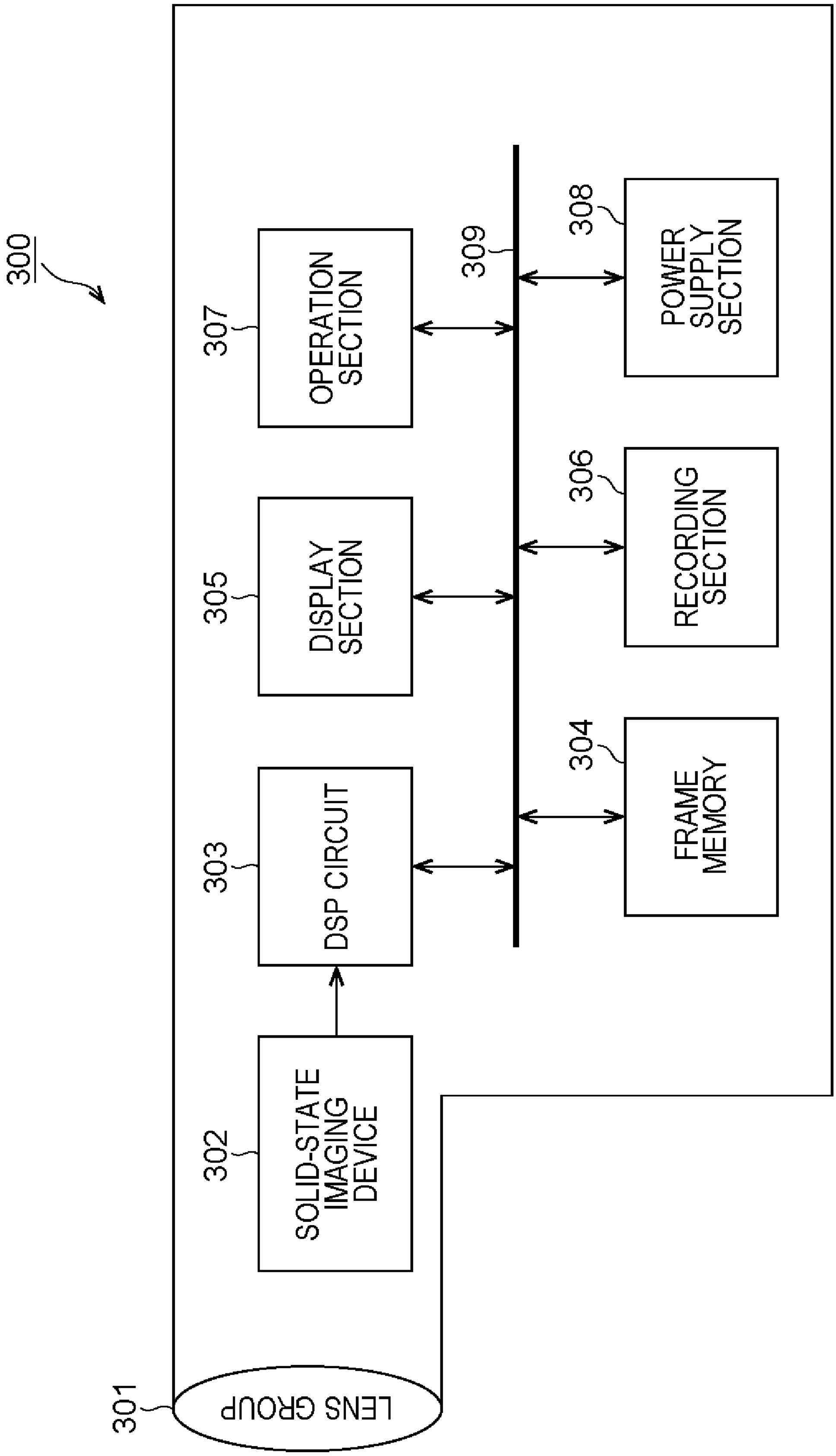
300
301
LENS GROUP
302
SOLID-STATE IMAGING DEVICE
303
DSP CIRCUIT
304
FRAME MEMORY
305
DISPLAY SECTION
306
RECORDING SECTION
307
OPERATION SECTION
308
POWER SUPPLY SECTION
309

FIG. 31

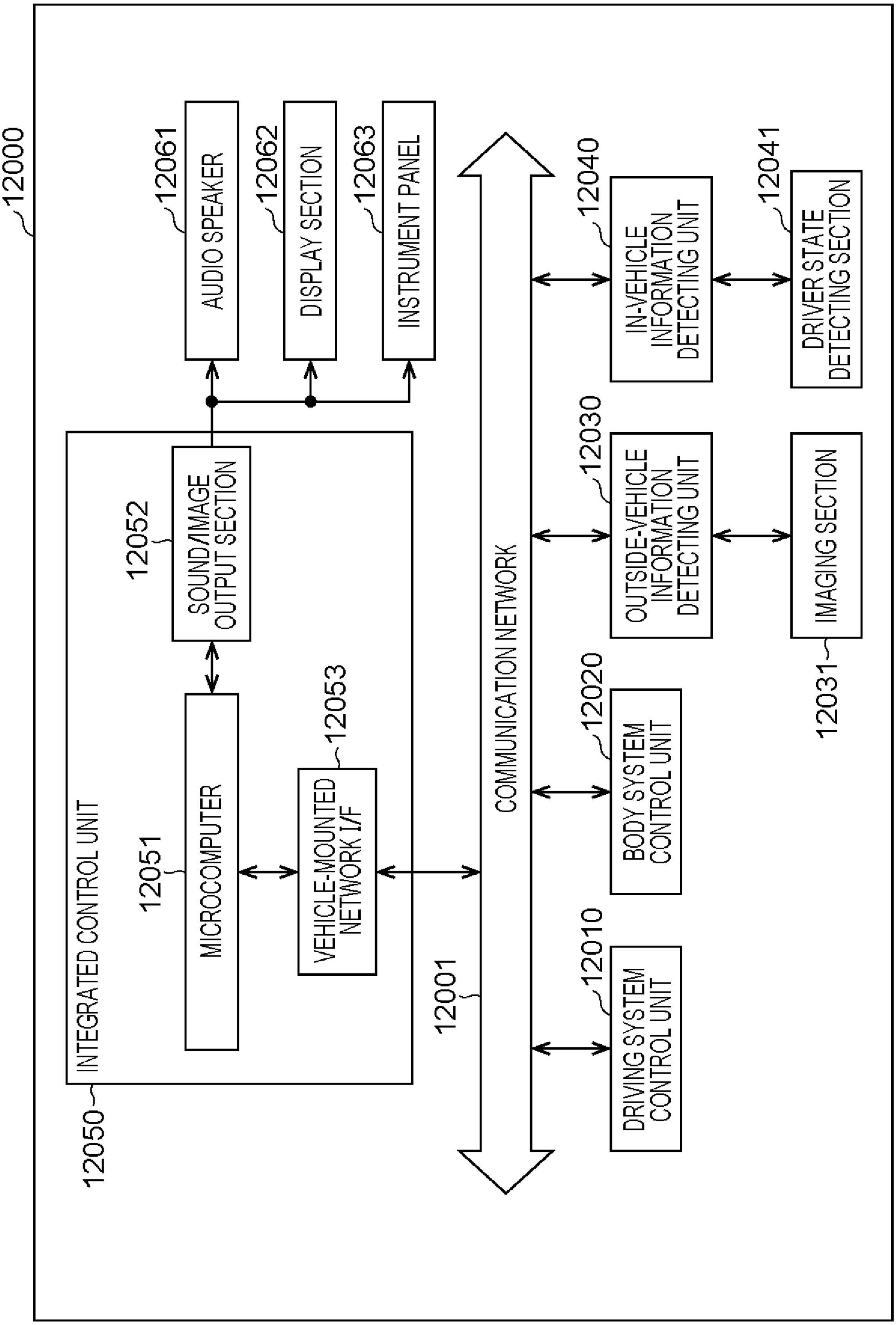
12000
12050
INTEGRATED CONTROL UNIT
12051
MICROCOMPUTER
12052
SOUND/IMAGE OUTPUT SECTION
12053
VEHICLE-MOUNTED NETWORK I/F
12061
AUDIO SPEAKER
12062
DISPLAY SECTION
12063
INSTRUMENT PANEL
12001
COMMUNICATION NETWORK
12010
DRIVING SYSTEM CONTROL UNIT
12020
BODY SYSTEM CONTROL UNIT
12030
OUTSIDE-VEHICLE INFORMATION DETECTING UNIT
12031
IMAGING SECTION
12040
IN-VEHICLE INFORMATION DETECTING UNIT
12041
DRIVER STATE DETECTING SECTION

FIG. 32

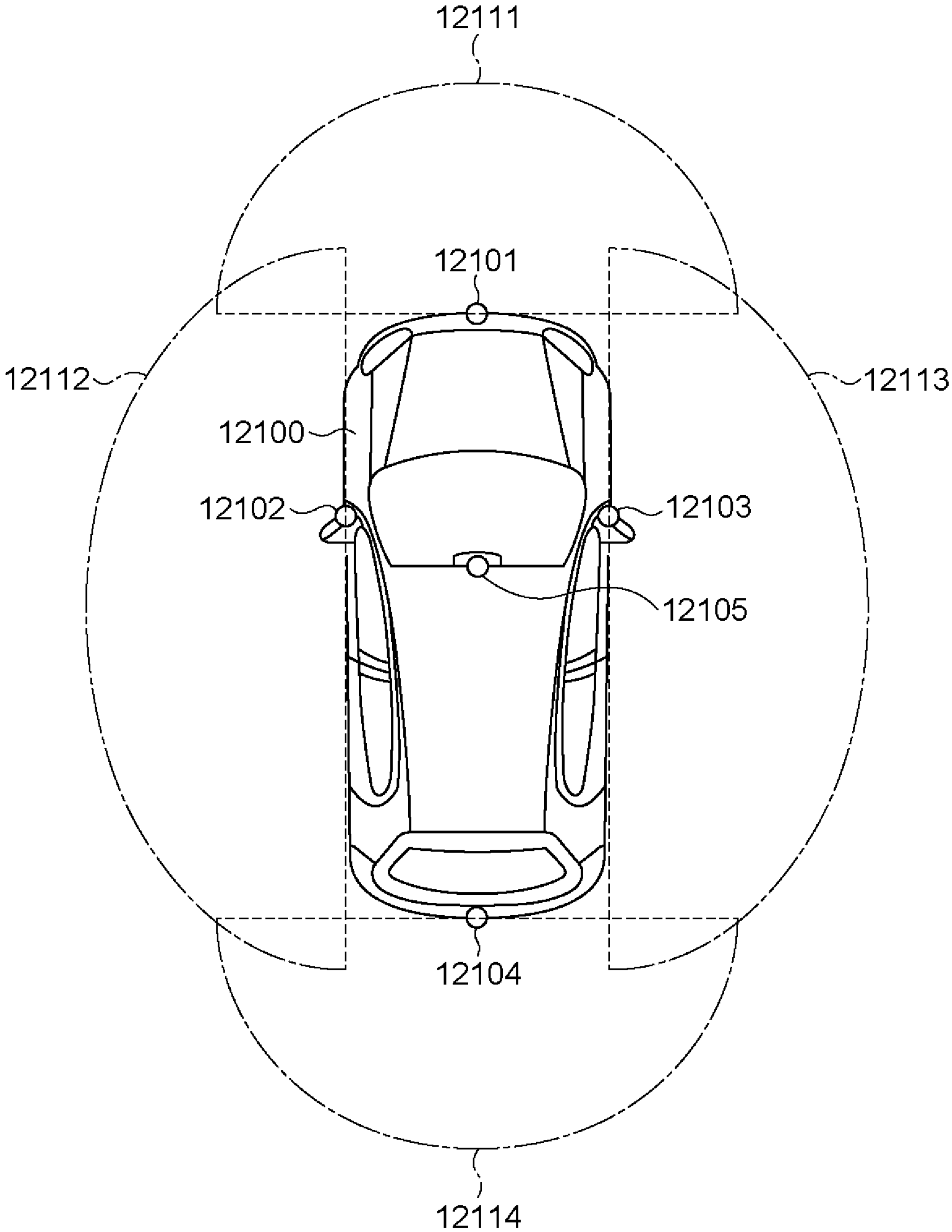
12111
12101
12112
12113
12100
12102
12103
12105
12104
12114

## INTERNATIONAL SEARCH REPORT

International application No.
**PCT/JP2023/009513**

**A. CLASSIFICATION OF SUBJECT MATTER**

***H01L 27/146***(2006.01)i; ***G02B 3/00***(2006.01)i; ***G02B 3/08***(2006.01)i; ***H04N 25/70***(2023.01)i
FI: H01L27/146 D; H04N25/70; G02B3/00 A; G02B3/08

According to International Patent Classification (IPC) or to both national classification and IPC

**B. FIELDS SEARCHED**

Minimum documentation searched (classification system followed by classification symbols)

H01L27/146; G02B3/00; G02B3/08; H04N25/70

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2016-57335 A (SONY CORP) 21 April 2016 (2016-04-21) paragraphs [0013], [0018], [0019], [0024]-[0027], [0029], [0088], [0091], fig. 1-16 | 1, 2, 4, 5, 7, 8, 10, 12, 29 |
| Y | | 3, 4, 6, 13-19, 23, 25, 26 |
| A | | 9, 11, 20-22, 24, 27, 28 |
| Y | JP 2019-160830 A (SONY SEMICONDUCTOR SOLUTIONS CORP) 19 September 2019 (2019-09-19) paragraphs [0080], [0086], fig. 1-13 | 3, 4, 13, 14 |
| Y | WO 2012/114714 A1 (PANASONIC CORPORATION) 30 August 2012 (2012-08-30) paragraphs [0005], [0048], fig. 1-7 | 6, 15-18, 23 |
| X | JP 2012-174885 A (SONY CORP) 10 September 2012 (2012-09-10) paragraphs [0022], [0043], [0044], fig. 1-21 | 28 |
| Y | | 19 |
| A | | 1-18, 20-27, 29 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 May 2023** | **06 June 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/009513**

**C. DOCUMENTS CONSIDERED TO BE RELEVANT**

| Category* | Citation of document, with indication, where appropriate, of the relevant passages | Relevant to claim No. |
|---|---|---|
| Y | JP 2002-182003 A (CANON INC) 26 June 2002 (2002-06-26)<br>paragraph [0072], fig. 1-14 | 25 |
| Y | WO 2020/003796 A1 (SONY SEMICONDUCTOR SOLUTIONS CORP) 02 January 2020 (2020-01-02)<br>paragraph [0081], fig. 1-25 | 26 |

Form PCT/ISA/210 (second sheet) (January 2015)

**INTERNATIONAL SEARCH REPORT**
**Information on patent family members**

International application No.
**PCT/JP2023/009513**

| Patent document cited in search report | Publication date (day/month/year) | Patent family member(s) | Publication date (day/month/year) |
|---|---|---|---|
| JP 2016-57335 A | 21 April 2016 | WO 2016/035245 A1<br>paragraphs [0013], [0018], [0019], [0024]-[0027], [0029], [0088], [0091], fig. 1-16 | |
| JP 2019-160830 A | 19 September 2019 | US 2021/0005656 A1<br>paragraphs [0105], [0113], fig. 1-13<br>WO 2019/171787 A1 | |
| WO 2012/114714 A1 | 30 August 2012 | US 2013/0148206 A1<br>paragraphs [0021], [0057], fig. 1-7 | |
| JP 2012-174885 A | 10 September 2012 | US 2012/0211850 A1<br>paragraphs [0041], [0061], [0062], fig. 1-21 | |
| JP 2002-182003 A | 26 June 2002 | US 2002/0089750 A1<br>paragraph [0091], fig. 1-14<br>EP 1215513 A1 | |
| WO 2020/003796 A1 | 02 January 2020 | US 2021/0273000 A1<br>paragraph [0117], fig. 1-25 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012174885 A